(19) **Europäisches Patentamt / European Patent Office / Office européen des brevets**

(11) **EP 4 672 942 A1**

(12) **EUROPEAN PATENT APPLICATION**

(43) Date of publication:
**31.12.2025 Bulletin 2026/01**

(21) Application number: **25182603.8**

(22) Date of filing: **13.06.2025**

(51) International Patent Classification (IPC):
**H10K 59/35** (2023.01)      **H10K 59/38** (2023.01)
**H10K 59/80** (2023.01)

(52) Cooperative Patent Classification (CPC):
**H10K 59/352; H10K 59/353; H10K 59/38;**
**H10K 59/8792**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **25.06.2024 KR 20240082968**
            **12.11.2024 KR 20240160176**

(71) Applicant: **Samsung Display Co., Ltd.
Yongin-si, Gyeonggi-do 17113 (KR)**

(72) Inventors:
• **GIL, Elly**
  **17113 Giheung-gu, Yongin-si, Gyeonggi-do (KR)**
• **JUNG, Soon Il**
  **17113 Giheung-gu, Yongin-si, Gyeonggi-do (KR)**
• **SHIN, Eon Pil**
  **17113 Giheung-gu, Yongin-si, Gyeonggi-do (KR)**
• **CHO, Jung Hyun**
  **17113 Giheung-gu, Yongin-si, Gyeonggi-do (KR)**
• **CHOI, Beohm Rock**
  **17113 Giheung-gu, Yongin-si, Gyeonggi-do (KR)**

(74) Representative: **Dr. Weitzel & Partner
Patent- und Rechtsanwälte mbB
Friedenstrasse 10
89522 Heidenheim (DE)**

(54) **DISPLAY DEVICE AND ELECTRONIC DEVICE**

(57) A display device and an electronic device are provided. The display device includes a display area in which a plurality of pixels including a plurality of emission areas spaced from each other is located, a color filter layer located in the display area and comprising a plurality of color filters overlapping the plurality of emission areas, and a light blocking layer located on the color filter layer and corresponding to the plurality of emission areas of some of the plurality of pixels, wherein the color filter layer comprises a light blocking area in which at least two of the plurality of color filters overlap, and a plurality of light transmitting areas, which are areas other than the light blocking area, and the light blocking area overlaps the light blocking layer, and the plurality of light transmitting areas do not overlap the light blocking layer.

EP 4 672 942 A1

**Description**

The present invention relates to a display device and an electronic device.

With the advance of information-oriented society, more and more demands are placed on display devices for displaying images in various ways. For example, display devices are employed in various electronic devices such as smartphones, digital cameras, laptop computers, navigation devices, and smart televisions.

The display device may be a flat panel display device such as a liquid crystal display device, a field emission display device and an organic light emitting display device. Among the flat panel display devices, in the light emitting display device, because each of pixels of a display panel includes a light emitting element capable of emitting light by itself, an image can be displayed without a backlight unit providing light to the display panel.

Aspects and features of embodiments of the present invention provide a display device and an electronic device capable of simplifying a structure, and providing a privacy protection mode by including a light blocking layer located in some pixels.

However, aspects and features of embodiments of the present invention are not restricted to the one set forth herein. The above and other aspects and features of embodiments of the present invention will become more apparent to one of ordinary skill in the art to which the present invention pertains by referencing the detailed description of the present invention given below.

The present invention is defined by the features of the independent claims. Preferred embodiments are provided in the dependent claims and the description.

According to one or more embodiments of the present invention, a display device includes a display area in which a plurality of pixels comprising a plurality of emission areas spaced from each other is located, a color filter layer located in the display area and comprising a plurality of color filters overlapping the plurality of emission areas, and a light blocking layer located on the color filter layer and corresponding to the plurality of emission areas of some of the plurality of pixels, wherein the color filter layer comprises a light blocking area in which at least two of the plurality of color filters overlap, and a plurality of light transmitting areas, which are areas other than the light blocking area, and the light blocking area overlaps the light blocking layer, and the plurality of light transmitting areas do not overlap the light blocking layer.

In an embodiment, the plurality of color filters comprise a first color filter, a second color filter, and a third color filter that transmit light of different colors, and the light blocking area comprises a region where at least the first color filter and the second color filter overlap in a thickness direction of the display device and a region where at least the first color filter and the third color filter overlap in the thickness direction.

In an embodiment, the plurality of color filters comprise a first color filter, a second color filter, and a third color filter, and the plurality of light transmitting areas comprise a region where only one color filter from among the first color filter, the second color filter, and the third color filter is located.

In an embodiment, the plurality of emission areas comprise a first emission area, a second emission area, and a third emission area spaced from each other, and the plurality of light transmitting areas comprise a first light transmitting area overlapping the first emission area, a second light transmitting area overlapping the second emission area, and a third light transmitting area overlapping the third emission area.

In an embodiment, the first color filter is around the first emission area and the second emission area in a plan view and overlaps the second color filter or the third color filter to form the light blocking area, the second color filter is around the second emission area and the third emission area in a plan view and overlaps the first color filter to form the light blocking area, and the third color filter is around the first emission area and the third emission area in a plan view and overlaps the first color filter to form the light blocking area.

In an embodiment, the light blocking layer comprises a first light output portion overlapping the first emission area, a second light output portion overlapping the second emission area, and a third light output portion overlapping the third emission area, an inner side surface of the first light transmitting area is aligned with an inner side surface of the first light output portion, an inner side surface of the second light transmitting area is aligned with an inner side surface of the second light output portion, and an inner side surface of the third light transmitting area is aligned with an inner side surface of the third light output portion.

In an embodiment, the plurality of emission areas comprise a first emission area, a second emission area, and a third emission area spaced from each other, and the first emission area, the second emission area, and the third emission area are located at different distances from the light blocking area.

In an embodiment, a distance between the first emission area and the light blocking area is smaller than a distance between the second emission area and the light blocking area, and is smaller than a distance between the third emission area and the light blocking area, and the distance between the second emission area and the light blocking area is larger than the distance between the third emission area and the light blocking area.

In an embodiment, the light blocking layer surrounds the plurality of emission areas in a plan view and comprises a plurality of light blocking patterns spaced from each other.

In an embodiment, the plurality of pixels comprise a first emission area, and a second emission area having a smaller radius than the first emission area, the light blocking layer comprises a first light blocking pattern corresponding to the first emission area, and a second light blocking pattern corresponding to the second emission area, and a difference between a radius of the first emission area and an inner radius of the first light blocking pattern is different from a difference between a radius of the second emission area and an inner radius of the second light blocking pattern.

In an embodiment, a width of the first light blocking pattern is smaller than a width of the second light blocking pattern.

In an embodiment, the plurality of pixels comprise a first pixel in which the light blocking layer is not located, and a second pixel in which the light blocking patterns are located to respectively correspond to the plurality of emission areas, and a diameter of the plurality of light transmitting areas in the first pixel is larger than a diameter of the plurality of light transmitting areas in the second pixel.

According to an aspect of the present invention, a display device comprises a substrate, a light emitting element layer located on the substrate and comprising a plurality of emission areas, an encapsulation layer located on the light emitting element layer, a color filter layer located on the encapsulation layer and comprising a plurality of light transmitting areas respectively overlapping the plurality of emission areas, and a light blocking area not overlapping the plurality of emission areas, and a light blocking member layer located on the color filter layer and comprising a light blocking layer located to respectively correspond to the plurality of emission areas, wherein the color filter layer comprises a first color filter, a second color filter, and a third color filter, and the light blocking area comprises a region where at least the first color filter and the second color filter overlap in a thickness direction and a region where at least the first color filter and the third color filter overlap in the thickness direction.

In an embodiment, the plurality of light transmitting areas comprise a region where only one color filter among the first color filter, the second color filter, and the third color filter is located in the thickness direction.

In an embodiment, the plurality of emission areas comprise a first emission area, a second emission area, and a third emission area spaced from each other, and the plurality of light transmitting areas comprise a first light transmitting area overlapping the first emission area, a second light transmitting area overlapping the second emission area, and a third light transmitting area overlapping the third emission area.

In an embodiment, the first color filter surrounds the first emission area and the second emission area in a plan view and overlaps the second color filter or the third color filter to form the light blocking area, the second color filter surrounds the second emission area and the third emission area in a plan view and overlaps the first color filter to form the light blocking area, and the third color filter surrounds the first emission area and the third emission area in a plan view and overlaps the first color filter to form the light blocking area.

According to an aspect of the present invention, a display device comprises a display area in which a plurality of pixels comprising a plurality of emission areas spaced from each other are located, a color filter layer located in the display area and comprising a plurality of color filters located to overlap the plurality of emission areas, and a light blocking layer located on the color filter layer and comprising a plurality of light blocking patterns located to correspond to the plurality of emission areas of some of the plurality of pixels and a light output portion overlapping the emission area, wherein the color filter layer comprises a light blocking area in which at least two of the plurality of color filters overlap, and a plurality of light transmitting areas, which are areas other than the light blocking area, and an inner side surface of the light blocking area is aligned with an inner side surface of the light output portion.

In an embodiment, the plurality of emission areas have a planar shape corresponding to a shape of inner perimeters of the plurality of light blocking patterns, and a shape of outer perimeters of the plurality of light blocking patterns is different from the shape of the inner perimeters.

In an embodiment, the planar shape of the plurality of emission areas and the shape of the inner perimeters of the plurality of light blocking patterns are elliptical, and the shape of the outer perimeters of the plurality of light blocking patterns is circular.

In an embodiment, the plurality of color filters comprise a first color filter, a second color filter, and a third color filter, and the light blocking area comprises a region where at least the first color filter and the second color filter overlap in a thickness direction and a region where at least the first color filter and the third color filter overlap in the thickness direction.

In an embodiment, the plurality of emission areas comprise a first emission area, a second emission area, and a third emission area spaced from each other, and the first emission area, the second emission area, and the third emission area have different distances from the light blocking area.

According to an aspect of the present invention, an electronic device comprises a display area in which a plurality of pixels comprising a plurality of emission areas spaced from each other are located, a color filter layer located in the display area and comprising a plurality of color filters located to overlap the plurality of emission areas, and a light blocking layer located on the color filter layer and located to correspond to the plurality of emission areas of some of the plurality of pixels, wherein the color filter layer comprises a light blocking area in which at least two of the plurality of color filters overlap, and a plurality of light transmitting areas, which are areas other than the light blocking area, and the light blocking area overlaps the light blocking layer, and the plurality of light transmitting areas do not overlap the light blocking layer.

The display device and the electronic device according to one embodiment may use color filters to form a light transmitting area and a light blocking area, and in conjunction with the light blocking layer, may control screen visibility at a specific viewing angle according to an emission mode of the display device. By designing the shapes and arrangements of an emission area, the light blocking area, and a light blocking pattern of the light blocking layer, the display device may block visibility at a specific viewing angle to provide a privacy protection mode to a user and improve luminance at the front.

It should be noted that effects of the present invention are not limited to those described above and other effects of the present invention will be apparent to those skilled in the art from the following descriptions.

## BRIEF DESCRIPTION OF THE DRAWINGS

The above and other aspects and features of embodiments of the present invention will become more apparent by describing in detail embodiments thereof with reference to the attached drawings, in which:

FIG. 1 is a schematic perspective view of an electronic device according to one or more embodiments;

FIG. 2 is a perspective view showing a display device included in an electronic device according to one or more embodiments;

FIG. 3 is a cross-sectional view of the display device of FIG. 2 viewed from the side;

FIG. 4 is a plan view of the arrangement of pixel electrodes in the display area of the display device according to one or more embodiments;

FIG. 5 is a plan view of the arrangement of emission areas and light blocking areas in the display area of the display device according to one or more embodiments;

FIG. 6 is a plan view showing the arrangement of emission areas and a first color filter in the display area of the display device according to one or more embodiments;

FIG. 7 is a plan view showing the arrangement of emission areas and a second color filter in the display area of the display device according to one or more embodiments;

FIG. 8 is a plan view showing the arrangement of emission areas and a third color filter in the display area of the display device according to one or more embodiments;

FIG. 9 is a plan view of the arrangement of emission areas and a light blocking layer in the display area of the display device according to one or more embodiments;

FIG. 10 is a schematic diagram illustrating light emitting pixels according to an emission mode of the display device according to one or more embodiments;

FIG. 11 is a cross-sectional view taken along the line X1-X1' of FIGS. 5 and 9;

FIG. 12 is a cross-sectional view taken along the line X2-X2' of FIGS. 5 and 9;

FIG. 13 is a cross-sectional view taken along the lines X3-X3' and X4-X4' of FIG. 9;

FIG. 14 is a diagram illustrating the relative arrangement of an emission area and a light blocking area located in one pixel of the display device according to one or more embodiments;

FIG. 15 is a diagram illustrating the relative arrangement of an emission area and color filters located in one pixel of the display device according to one or more embodiments;

FIG. 16 is a diagram illustrating the relative arrangement of an emission area and a light blocking layer located in the second type pixel of the display device according to one or more embodiments;

FIG. 17 is a schematic diagram illustrating the relative arrangement of an emission area and a light blocking layer located in the second type pixel of the display device according to one or more embodiments;

FIG. 18 is an diagram illustrating an emission direction of light emitted from an emission area of a display device and a relative arrangement of a light blocking layer;

FIG. 19 is a plan view of the arrangement of emission areas in a display area of a display device according to one or more embodiments;

FIG. 20 is a plan view showing the arrangement of an emission area and a light blocking area in the display area of the display device of FIG. 19;

FIG. 21 is a plan view showing the arrangement of an emission area and a light blocking layer in the display area of the display device of FIG. 19;

FIG. 22 is a diagram showing the relative arrangement of an emission area and a light blocking layer of the display device of FIG. 21;

FIG. 23 is a table illustrating a 45-degree luminance ratio and a color variation according to an azimuth angle based on the shape of the outer perimeter of a light blocking pattern; and

FIGS. 24 and 25 are views showing a light blocking pattern of a display device according to one or more embodiments.

## DETAILED DESCRIPTION

The present invention will now be described more fully hereinafter with reference to the accompanying drawings, in which embodiments of the invention are shown. The present invention may, however, be embodied in different forms and should not be construed as limited to embodiments set forth herein. Rather, these embodiments are provided so that the present disclosure will be thorough and complete, and will fully convey the scope of the present invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings and scope of the present invention. Similarly, the second element could also be termed the first element.

Each of the features of the various embodiments of the present invention may be combined or combined with each other, in part or in whole, and technically various interlocking and driving are possible. Each embodiment may be implemented independently of each other or may be implemented together in an association.

A person of ordinary skill in the art would appreciate, in view of the present disclosure in its entirety, that each suitable feature of the various embodiments of the present invention may be combined or combined with each other, partially or entirely, and may be technically interlocked and operated in various suitable ways, and each embodiment may be implemented independently of each other or in conjunction with each other in any suitable manner unless otherwise stated or implied.

Hereinafter, embodiments will be described with reference to the accompanying drawings.

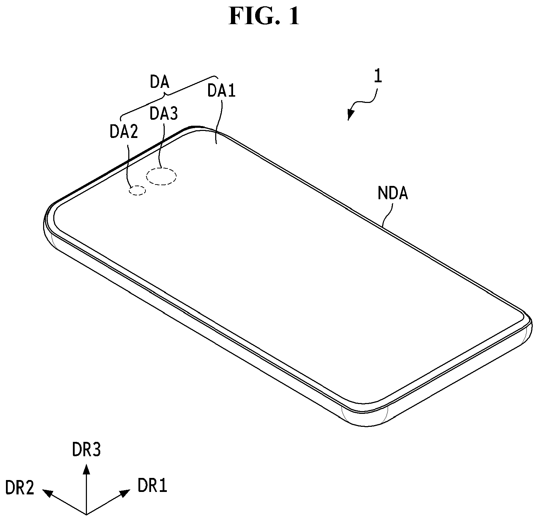

FIG. 1 is a schematic perspective view of an electronic device according to one or more embodiments.

Referring to FIG. 1, an electronic device 1 displays a moving image and/or a still image. The electronic device 1 may refer to any electronic device providing a display screen. Examples of the electronic device 1 may include a television, a laptop computer, a monitor, a billboard, an Internet-of-Things (IoTs) device, a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation device, a game machine, a digital camera, a camcorder, and/or the like, which provide a display screen.

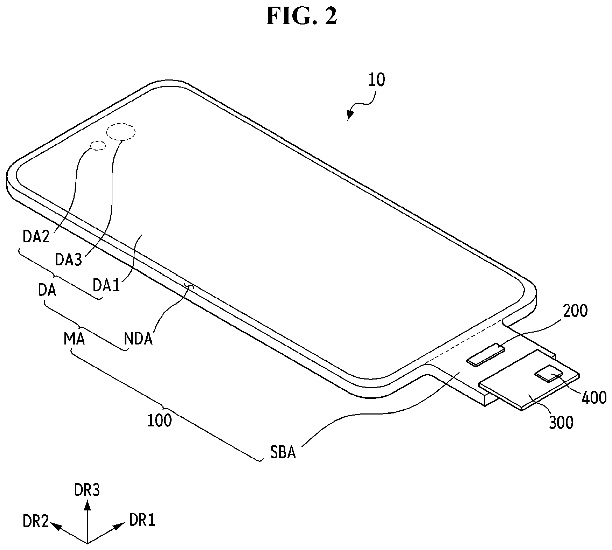

The electronic device 1 may include a display device 10 (see FIG. 2) providing a display screen. Examples of the display device may include an inorganic light emitting diode display device, an organic light emitting display device, a quantum dot light emitting display device, a plasma display device, and a field emission display device. In the following description, a case where an organic light emitting diode (OLED) display device is applied as a display device will be shown as examples, but the present invention is not limited thereto, and other display devices may be applied.

The shape of the electronic device 1 may be variously modified. For example, the electronic device 1 may have a shape such as a rectangular shape elongated in a horizontal direction, a rectangular shape elongated in a vertical direction, a square shape, a quadrilateral shape with rounded corners (vertices), other polygonal shapes/ and/or a circular shape. The shape of a display area DA of the electronic device 1 may also be similar to the overall shape of the electronic device 1. FIG. 1 illustrates the electronic device 1 having a rectangular shape elongated in a second direction DR2.

The electronic device 1 may include the display area DA and a non-display area NDA along an edge or a periphery of the display area DA. The display area DA is an area where an image can be displayed, and the non-display area NDA is an area where an image is not displayed. The display area DA may also be referred to as an active region, and the non-display area NDA may also be referred to as a non-active region. The display area DA may substantially occupy the center of the electronic device 1.

The display area DA may include a first display area DA1, a second display area DA2, and a third display area DA3. The second display area DA2 and the third display area DA3 are areas in which components for adding various functions to the electronic device 1 are located, and the second display area DA2 and the third display area DA3 may correspond to a component area.

FIG. 2 is a perspective view showing a display device included in an electronic device according to one or more embodiments.

Referring to FIG. 2, the electronic device 1 according to one or more embodiments may include the display device 10. The display device 10 may provide an image displayed by the electronic device 1. The display device 10 may have a planar shape similar to the shape of the electronic device 1. For example, the display device 10 may have a shape similar to a rectangular shape having a short side in a first direction DR1 and a long side in the second direction DR2. The edge where the short side in the first direction DR1 and the long side in the second direction DR2 meet may be rounded to have a curvature, but is not limited thereto and may be formed at a right angle. The planar shape of the display device 10 is not limited to a quadrilateral shape, and may be formed in a shape similar to another polygonal shape, a circular shape, or elliptical shape.

The display device 10 may include a display panel 100, a display driver 200, a circuit board 300, and a touch driver 400.

The display panel 100 may include a main region MA and a sub-region SBA.

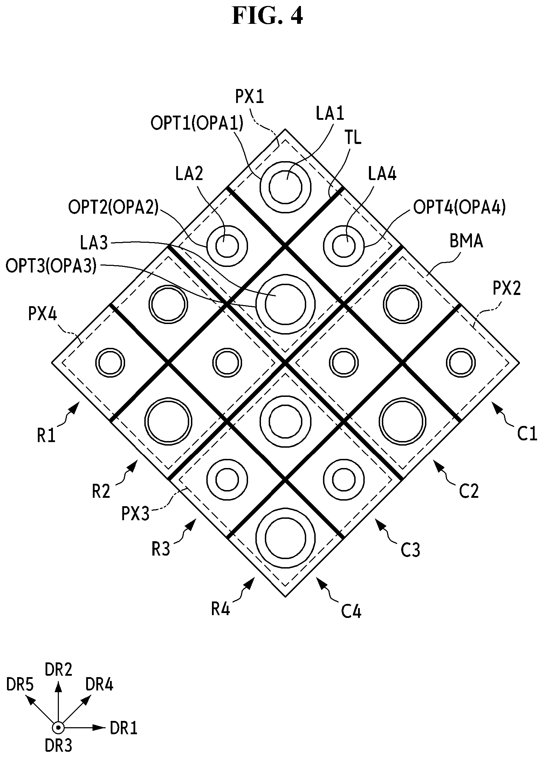

The main region MA may include the display area DA including pixels PX1, PX2, PX3, and PX4 (see FIG. 4) that display an image, and the non-display area NDA located around the display area DA. The display area DA may be located in the center of the main region MA, and the non-display area NDA may be around (e.g.,

may surround) the display area DA. The display area DA may include the first display area DA1, the second display area DA2, and the third display area DA3. The display area DA may emit light from a plurality of emission areas or a plurality of opening areas. For example, the display panel 100 may include a pixel circuit including switching elements, a pixel defining film defining an emission area or an opening area, and a self-light emitting element.

For example, the self-light emitting element may include at least one of an organic light emitting diode (LED) including an organic light emitting layer, a quantum dot LED including a quantum dot light emitting layer, an inorganic LED including an inorganic semiconductor, or a micro LED, but is not limited thereto.

The non-display area NDA may be an area outside the display area DA. The non-display area NDA may be defined as an edge area of the main region MA of the display panel 100. The non-display area NDA may include a gate driver that supplies gate signals to the gate lines, and fan-out lines that connect the display driver 200 to the display area DA.

The sub-region SBA may be a region extending from one side of the main region MA. The sub-region SBA may include a flexible material that can be bent, folded, and/or rolled. For example, when the sub-region SBA is bent, the sub-region SBA may overlap the main region MA in a thickness direction (e.g., a third direction DR3). The sub-region SBA may include the display driver 200 and a pad portion connected to the circuit board 300. In another embodiment, the sub-region SBA may be omitted, and the display driver 200 and the pad portion may be located in the non-display area NDA.

The display driver 200 may output signals and voltages for driving the display panel 100. The display driver 200 may supply data voltages to data lines. The display driver 200 may supply a power voltage to the power line and may supply a gate control signal to the gate driver. The display driver 200 may be formed as an integrated circuit (IC) and mounted on the display panel 100 by a chip on glass (COG) method, a chip on plastic (COP) method, or an ultrasonic bonding method. For example, the display driver 200 may be located in the sub-region SBA, and may overlap the main region MA in the thickness direction by bending of the sub-region SBA. For another example, the display driver 200 may be mounted on the circuit board 300.

The circuit board 300 may be attached to the pad portion of the display panel 100 by using an anisotropic conductive film (ACF). Lead lines of the circuit board 300 may be electrically connected to the pad portion of the display panel 100. The circuit board 300 may be a flexible printed circuit board (FPCB), a printed circuit board (PCB), or a flexible film such as a chip on film.

The touch driver 400 may be mounted on the circuit board 300. The touch driver 400 may be connected to a touch sensing unit of the display panel 100. The touch driver 400 may supply a touch driving signal to a plurality of touch electrodes of the touch sensing unit and may sense an amount of change in capacitance between the plurality of touch electrodes. For example, the touch driving signal may be a pulse signal having a suitable frequency (e.g., a predetermined frequency). The touch driver 400 may calculate whether an input is made and input coordinates based on an amount of change in capacitance between the plurality of touch electrodes. The touch driver 400 may be formed as an integrated circuit (IC).

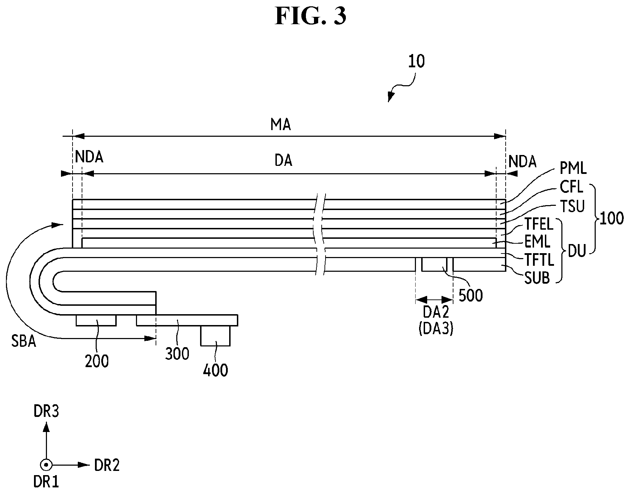

FIG. 3 is a cross-sectional view of the display device of FIG. 2 viewed from the side. FIG. 3 illustrates the sub-region SBA of the display panel 100 in a folded state in the display device 10 of FIG. 2.

Referring to FIG. 3, the display panel 100 may include a display layer DU, a touch sensing layer TSU, a color filter layer CFL, and a light blocking member layer PML. The display layer DU may include a substrate SUB, a thin film transistor layer TFTL, a light emitting element layer EML, and an encapsulation layer TFEL.

The substrate SUB may be a base substrate or a base member. The substrate SUB may be a flexible substrate that can be bent, folded, and/or rolled. For example, the substrate SUB may include a polymer resin such as polyimide (PI), but is not limited thereto. In another embodiment, the substrate SUB may include a glass material and/or a metal material.

The thin film transistor layer TFTL may be located on the substrate SUB. The thin film transistor layer TFTL may include a plurality of thin film transistors constituting a pixel circuit of pixels. The thin film transistor layer TFTL may further include gate lines, data lines, power lines, gate control lines, fan-out lines that connect the display driver 200 to the data lines, and lead lines that connect the display driver 200 to the pad portion. Each of the thin film transistors may include a semiconductor region, a source electrode, a drain electrode, and a gate electrode. For example, when the gate driver is formed on one side of the non-display area NDA of the display panel 100, the gate driver may include thin film transistors.

The thin film transistor layer TFTL may be located in the display area DA, the non-display area NDA, and the sub-region SBA. Thin film transistors, gate lines, data lines, and power lines of each of the pixels of the thin film transistor layer TFTL may be located in the display area DA. Gate control lines and fan-out lines of the thin film transistor layer TFTL may be located in the non-display area NDA. The lead lines of the thin film transistor layer TFTL may be located in the sub-region SBA.

The light emitting element layer EML may be located on the thin film transistor layer TFTL. The light emitting element layer EML may include a plurality of light emitting elements each including a first electrode, a second electrode, and a light emitting layer to emit light, and a pixel defining film defining pixels. The plurality of light emitting elements of the light emitting element layer EML may be located in the display area DA.

In one or more embodiments, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer TFTL and the second electrode receives the cathode voltage, holes and electrons may be transferred to the organic light emitting layer through the hole transporting layer and the electron transporting layer, respectively and may be combined with each other to emit light in the organic light emitting layer.

In another embodiment, the light emitting elements may include a quantum dot light emitting diode including a quantum dot light emitting layer, an inorganic light emitting diode including an inorganic semiconductor, and/or a micro light emitting diode.

The encapsulation layer TFEL may cover the top surface and the side surface of the light emitting element layer EML, and may protect the light emitting element layer EML. The encapsulation layer TFEL may include at least one inorganic film and at least one organic film for encapsulating the light emitting element layer EML.

The touch sensing layer TSU may be located on the encapsulation layer TFEL. The touch sensing layer TSU may include a plurality of touch electrodes for sensing a user's touch in a capacitive manner, and touch lines connecting the plurality of touch electrodes to the touch driver 400. For example, the touch sensing layer TSU may sense the user's touch by using a mutual capacitance method or a self-capacitance method.

In another embodiment, the touch sensing layer TSU may be located on a separate substrate located on the display layer DU. In this case, the substrate supporting the touch sensing layer TSU may be a base member that encapsulates the display layer DU.

The plurality of touch electrodes of the touch sensing layer TSU may be located in a touch sensor area overlapping the display area DA. The touch lines of the touch sensing layer TSU may be located in a touch peripheral area that overlaps the non-display area NDA.

The color filter layer CFL may be located on the touch sensing layer TSU. The color filter layer CFL may include a plurality of color filters respectively corresponding to the plurality of emission areas. Each of the color filters may selectively transmit light of a specific wavelength and may block or absorb light of a different wavelength. The color filter layer CFL may absorb a portion of light coming from the outside of the display device 10 to reduce reflected light due to external light. Accordingly, the color filter layer CFL may prevent color distortion caused by reflection of the external light.

Because the color filter layer CFL is directly located on the touch sensing layer TSU, the display device 10 may not require a separate substrate for the color filter layer CFL. Accordingly, the thickness of the display device 10 may be relatively small.

The light blocking member layer PML may be located on the color filter layer CFL. The light blocking member layer PML may include light blocking patterns located to correspond to specific pixels of the display layer DU. The display device 10 may include the light blocking member layer PML to control visibility at a specific viewing angle and provide a privacy protection mode to the user.

In one or more embodiments, the display device 10 may further include an optical device 500. The optical device 500 may be located in the second display area DA2 or the third display area DA3. The optical device 500 may emit or receive light in infrared, ultraviolet, and/or visible light bands. For example, the optical device 500 may be an optical sensor that detects light incident on the display device 10 such as a proximity sensor, an illuminance sensor, and/or a camera sensor or an image sensor.

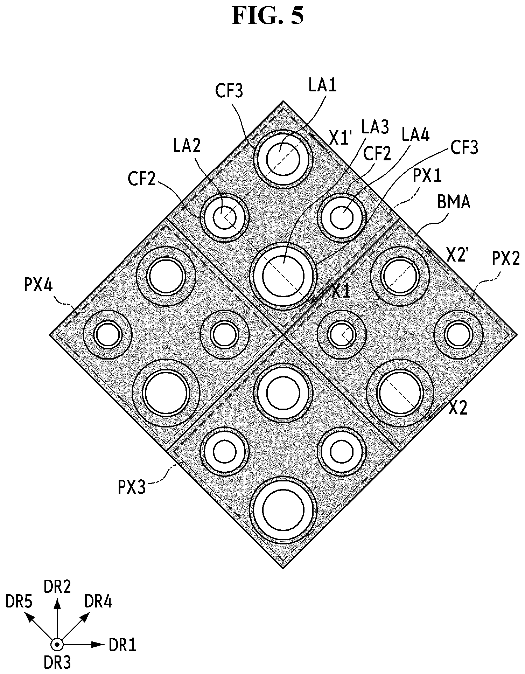

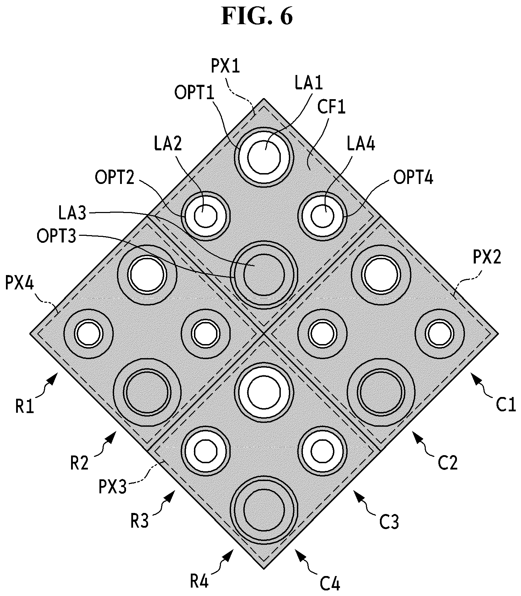

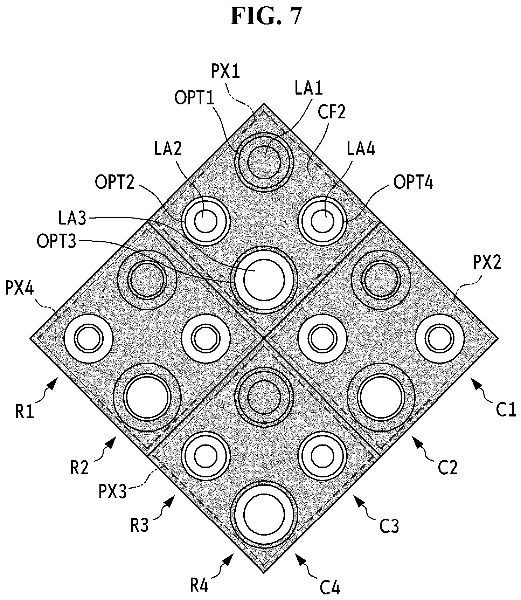

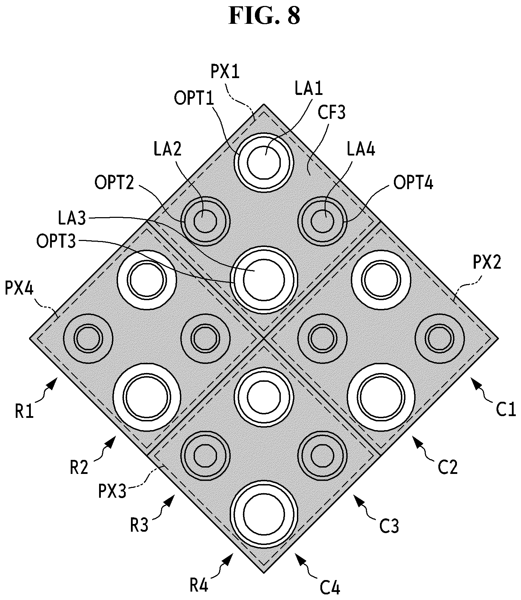

FIG. 4 is a plan view of the arrangement of pixel electrodes in the display area of the display device according to one or more embodiments. FIG. 5 is a plan view of the arrangement of emission areas and light blocking areas in the display area of the display device according to one or more embodiments. FIG. 6 is a plan view showing the arrangement of emission areas and a first color filter in the display area of the display device according to one or more embodiments. FIG. 7 is a plan view showing the arrangement of emission areas and a second color filter in the display area of the display device according to one or more embodiments. FIG. 8 is a plan view showing the arrangement of emission areas and a third color filter in the display area of the display device according to one or more embodiments.

Referring to FIGS. 4 and 5, the display device 10 may include a plurality of pixels PX1, PX2, PX3, and PX4 located in the display area DA. The plurality of pixels PX1, PX2, PX3, and PX4 may be arranged along a fourth direction DR4 and a fifth direction DR5, which are diagonal directions between the first direction DR1 and the second direction DR2. The first pixel PX1 and the second pixel PX2 may be located adjacent to each other in the fifth direction DR5, and the second pixel PX2 and the third pixel PX3 may be located adjacent to each other in the fourth direction DR4. The third pixel PX3 and the fourth pixel PX4 may be located adjacent to each other in the fifth direction DR5. The plurality of pixels PX1, PX2, PX3, and PX4 may be repeatedly located in the arrangement of FIG. 4 over the entire display area DA.

Each of the plurality of pixels PX1, PX2, PX3, and PX4 may include a plurality of emission areas LA1, LA2, LA3, and LA4. For example, each of the pixels PX1, PX2, PX3, and PX4 may include a first emission area LA1, a second emission area LA2, a third emission area LA3, and a fourth emission area LA4. However, the present invention is not limited thereto. The number of emission areas LA1, LA2, LA3, and LA4 located in the pixels PX1, PX2, PX3, and PX4 may be variously modified.

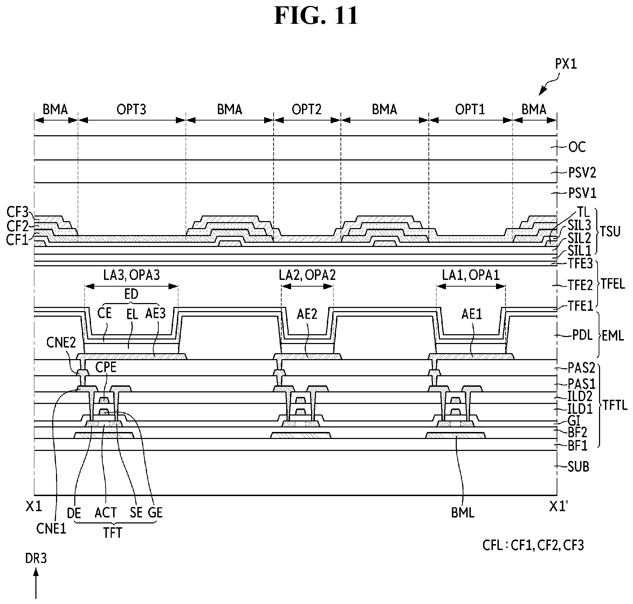

One pixel PX1, PX2, PX3, PX4 may include one or more light emitting elements ED (see FIG. 11), and the light emitting elements may be light emitting elements that emit light of different colors. For example, a light emitting element in the first emission area LA1 may emit first light of a red color. A light emitting element in the second emission area LA2 may emit second light of a green color, and a light emitting element in the third emission area LA3 may emit third light of a blue color. In addition, the light emitting element in the fourth emission area LA4 may emit second light of a green color. However, the present invention is not limited thereto.

Each of the emission areas LA1, LA2, LA3, and LA4 may emit light of various colors. For example, the first emission area LA1 may emit the first light of the red color, the second emission area LA2 may emit the second light of the green color, the third emission area LA3 may emit the third light of the blue color, and the fourth emission area LA4 may emit the second light of the green color. In one or more embodiments, each of the emission areas LA1, LA2, LA3, LA4 of the display device 10 may be an area overlapping a pixel electrode. For example, openings OPA1, OPA2, and OPA3 of a pixel defining film PDL illustrated in FIG. 11 may correspond to the emission areas LA1, LA2, LA3, and LA4. For example, the emission areas LA1, LA2, LA3, and LA4 may be defined by the plurality of openings OPA1, OPA2, and OPA3 formed in the pixel defining film PDL (see FIG. 11) of the light emitting element layer EML, which will be described later. The first emission area LA1 may be defined by the first opening OPA1 of the pixel defining film that overlaps a first pixel electrode AE1, the second emission area LA2 may be defined by the second opening OPA2 of the pixel defining film that overlaps a second pixel electrode AE2, and the third emission area LA3 may be defined by the third opening OPA3 of the pixel defining film that overlaps a third pixel electrode AE3. In one or more embodiments, the fourth emission area LA4 may be defined by a fourth opening that overlaps a fourth pixel electrode of the pixel defining film.

The plurality of emission areas LA1, LA2, LA3, and LA4 may be located in a PENTILE® type arrangement, for example, a diamond PENTILE® type arrangement. PENTILE® is a registered trademark of Samsung Display Co., Ltd., Republic of Korea. The first direction DR1 may be a row direction, and the second direction DR2 may be a column direction. For example, the first emission area LA1 and the third emission area LA3 may be spaced (e.g., spaced apart) from each other in the second direction DR2, and they may be alternately arranged along the first direction DR1 and the second direction DR2. The second emission area LA2 and the fourth emission area LA4 may be spaced (e.g., spaced apart) from each other in the first direction DR1, and may be spaced (e.g., spaced apart) from the adjacent first emission area LA1 and the adjacent third emission area LA3 in the fourth direction DR4 or the fifth direction DR5. The second emission area LA2 and the fourth emission area LA4 may be repeatedly (or alternately) arranged along the first direction DR1 and the second direction DR2, and the second emission area LA2 and the first emission area LA1, or the fourth emission area LA4 and the third emission area LA3 may be alternately arranged along the fourth direction DR4 or the fifth direction DR5.

In one or more embodiments, the areas or sizes of the first to fourth emission areas LA1, LA2, LA3, and LA4 may be different from each other. In the embodiment of FIG. 4, the area of the third emission area LA3 may be greater than the areas of the first emission area LA1, the second emission area LA2, and the fourth emission area LA4, and the area of the first emission area LA1 may be greater than the areas of the second emission area LA2 and the fourth emission area LA4. The intensity of light emitted may vary according to the areas of the emission areas LA1, LA2, LA3, and LA4, and the areas of the emission areas LA1, LA2, LA3, and LA4 may be adjusted to control the color of the image displayed on the display device 10 or the electronic device 1. In the embodiment of FIG. 4, the third emission area LA3 having the largest area is illustrated, but is not limited thereto. The sizes and areas of the emission areas LA1, LA2, LA3, and LA4 may be freely adjusted depending on the color of the image required in the display device 10 or the electronic device 1. For example, the emission areas LA1, LA2, LA3, and LA4 may have the same size and the same area. In addition, the areas of the emission areas LA1, LA2, LA3, and LA4 may be related to light emission efficiency and the lifespan of the light emitting element ED, and may have a trade-off relationship with the reflection by external light. The areas of the emission areas LA1, LA2, LA3, and LA4 may be adjusted in consideration of the above factors.

The display device 10 may include the color filter layer CFL located on the emission areas LA1, LA2, LA3, and LA4. The color filter layer CFL may include the plurality of color filters CF1, CF2, and CF3. The color filter layer CFL may include a light blocking area BMA and a plurality of light transmitting areas OPT1, OPT2, OPT3, and OPT4. The light blocking area BMA may be a region where at least two of the plurality of color filters CF1, CF2, and CF3 overlap in the thickness direction (e.g., the third direction DR3). For example, the light blocking area BMA may be a region where at least a first color filter CF1 and a second color filter CF2 overlap, or at least the first color filter CF1 and a third color filter CF3 overlap. The light blocking area BMA may be located over the entire display area DA.

The plurality of light transmitting areas OPT1, OPT2, OPT3, and OPT4 may be located to correspond to the emission areas LA1, LA2, LA3, and LA4, respectively, between the light blocking areas BMA. The plurality of light transmitting areas OPT1, OPT2, OPT3, and OPT4 may be located to correspond to the openings OPA1, OPA2, OPA3, and OPA4 in the pixel defining film PDL (see FIG. 11), respectively. The plurality of light transmitting areas OPT1, OPT2, OPT3, and OPT4 may be regions where one of the plurality of color filters CF1, CF2, and CF3 is located when viewed in the thickness direction (e.g., the third direction DR3). For example, the plurality of light transmitting areas OPT1, OPT2, OPT3, and OPT4 may be the remaining regions excluding the region where at least two of the plurality of color filters CF1, CF2, and CF3 overlap.

The light blocking area BMA may be located on the display area DA, excluding the regions where the light transmitting areas OPT1, OPT2, OPT3, and OPT4 are located in the display area DA. The light transmitting areas OPT1, OPT2, OPT3, and OPT4 may be areas through which light emitted from the light emitting elements corresponding to the respective emission areas LA1, LA2, LA3, and LA4 is outputted. The plurality of light transmitting areas OPT1, OPT2, OPT3, and OPT4 may include a first light transmitting area OPT1 overlapping the first emission area LA1, a second light transmitting area OPT2 overlapping the second emission area LA2, a third light transmitting area OPT3 overlapping the third emission area LA3, and a fourth light transmitting area OPT4 overlapping the fourth emission area LA4.

The areas of the plurality of light transmitting areas OPT1, OPT2, OPT3, and OPT4 in a plan view may be larger than the areas of the emission areas LA1, LA2, LA3, and LA4 in a plan view, respectively. For example, the first light transmitting area OPT1 may have a larger area in a plan view than the first emission area LA1. The second light transmitting area OPT2 may have a larger area in a plan view than the second emission area LA2. The third light transmitting area OPT3 may have a larger area in a plan view than the third emission area LA3. The fourth light transmitting area OPT4 may have a larger area in a plan view than the fourth emission area LA4.

In addition, the light transmitting areas OPT1, OPT2, OPT3, and OPT4 may have different areas in a plan view. As described above, the areas of the plurality of emission areas LA1, LA2, LA3, and LA4 may be different from each other, and accordingly, the sizes of the light transmitting areas OPT1, OPT2, OPT3, and OPT4 may also be different from each other. For example, the diameter or size of the third light transmitting area OPT3 may be larger than that of the first light transmitting area OPT1, the second light transmitting area OPT2, and the fourth light transmitting area OPT4. The diameter or size of the first light transmitting area OPT1 may be larger than that of the second light transmitting area OPT2 and the fourth light transmitting area OPT4. However, the present invention is not limited thereto.

In one or more embodiments, the difference between the diameter of the emission area LA1, LA2, LA3, LA4 and the diameter of the light transmitting area OPT1, OPT2, OPT3, OPT4 in the same pixel PX1, PX2, PX3, PX4, or the separation distance between the inner side surface of the opening OPA1, OPA2, OPA3, OPA4 and the inner side surface of the light transmitting area OPT1, OPT2, OPT3, OPT4 may be different depending on the type of the emission areas LA1, LA2, LA3, and LA4 or the light transmitting areas OPT1, OPT2, OPT3, and OPT4. For example, the separation distance between the third emission area LA3 and the third light transmitting area OPT3, or the difference between the diameter of the third emission area LA3 and the diameter of the third light transmitting area OPT3 may be larger than the separation distance between the first emission area LA1 and the first light transmitting area OPT1, or the difference between the diameter of the first emission area LA1 and the diameter of the first light transmitting area OPT1, and may be smaller than the separation distance between the second emission area LA2 and the second light transmitting area OPT2, or the difference between the diameter of the second emission area LA2 and the diameter of the second light transmitting area OPT2. The separation distance between the first emission area LA1 and the first light transmitting area OPT1, or the difference between the diameter of the first emission area LA1 and the diameter of the first light transmitting area OPT1 may be smaller than the separation distance between the second emission area LA2 and the second light transmitting area OPT2, or the difference between the diameter of the second emission area LA2 and the diameter of the second light transmitting area OPT2. On the other hand, the separation distance between the second emission area LA2 and the second light transmitting area OPT2, or the difference between the diameter of the second emission area LA2 and the diameter of the second light transmitting area OPT2 may be equal to the separation distance between the fourth emission area LA4 and the fourth light transmitting area OPT4, or the difference between the diameter of the fourth emission area LA4 and the diameter of the fourth light transmitting area OPT4.

According to one or more embodiments, the display device 10 may include the pixels PX1, PX2, PX3, and PX4 having different separation distances between the emission areas LA1, LA2, LA3, and LA4 and the light transmitting areas OPT1, OPT2, OPT3, and OPT4. For example, in the first pixel PX1 and the third pixel PX3, the separation distances between the emission areas LA1, LA2, LA3, and LA4 and the light transmitting areas OPT1, OPT2, OPT3, and OPT4 may be equal to each other. Also in the second pixel PX2 and the fourth pixel PX4, the separation distances between the emission areas LA1, LA2, LA3, and LA4 and the light transmitting areas OPT1, OPT2, OPT3, and OPT4 may be equal to each other. However, in the first pixel PX1 and the second pixel PX2, the separation distances between the emission areas LA1, LA2, LA3, and LA4 and the light transmitting areas OPT1, OPT2, OPT3, and OPT4 may be different from each other. In one or more embodiments, the separation distance between the emission areas LA1, LA2, LA3, and LA4 and the light transmitting areas OPT1, OPT2, OPT3, and OPT4 in the first pixel PX1 and the third pixel PX3 may be greater than the separation distance between the emission areas LA1, LA2, LA3, and LA4 and the light transmitting areas OPT1, OPT2, OPT3, and OPT4 in the second pixel PX2 and the fourth pixel PX4. In the second pixel PX2 and the fourth pixel PX4, the diameter difference between the emission areas LA1, LA2, LA3, and LA4 and the light transmitting areas OPT1, OPT2, OPT3, and OPT4 may be small, and the inner side surfaces of the openings OPA1, OPA2, OPA3, and OPA4 and the inner side surfaces of the light transmitting areas OPT1, OPT2, OPT3, and OPT4 may be located adjacent to each other in a plan view.

The display device 10 may include a first type pixel such as the first pixel PX1 and the third pixel PX3, and a second type pixel such as the second pixel PX2 and the fourth pixel PX4. The distinction between the first type pixel and the second type pixel may be made not only by the separation distance between the emission areas LA1, LA2, LA3, and LA4 and the light transmitting areas OPT1, OPT2, OPT3, and OPT4, but also by the presence/absence of a light blocking layer BM to be described later. For example, the light blocking layer BM may not be located in the first pixel PX1 and the third pixel PX3, and the light blocking layer BM may be located in the second pixel PX2 and the fourth pixel PX4. The light blocking layer BM will be described later with reference to other drawings.

Referring to FIGS. 6 - 8, each of the plurality of color filters CF1, CF2, and CF3 may be located to correspond to the emission areas LA1, LA2, LA3, and LA4. For example, the plurality of color filters CF1, CF2, and CF3 may be formed to overlap the openings OPA1, OPA2, OPA3, and OPA4 of the pixel defining film PDL (see FIG. 11), and may form the light transmitting areas OPT1, OPT2, OPT3, and OPT4 through which light emitted from the emission areas LA1, LA2, LA3, and LA4 is outputted.

The color filters CF1, CF2, and CF3 may have a larger area than the emission areas LA1, LA2, LA3, and LA4 and may completely cover the emission areas LA1, LA2, LA3, and LA4. The color filters CF1, CF2, and CF3 may completely cover the light transmitting areas OPT1, OPT2, OPT3, and OPT4, and a portion of each color filter may be located to overlap other color filters CF1, CF2, and CF3.

The color filters CF1, CF2, and CF3 may be located to correspond to different emission areas LA1, LA2, LA3, and LA4, and may include the first color filter CF1, the second color filter CF2, and the third color filter CF3 that transmit light of different colors. The color filters CF1, CF2, and CF3 may include a colorant such as a dye or a pigment that absorbs light in a wavelength band other than a specific wavelength band, and may be located to correspond to the color of the light emitted from the light emitting element in the emission areas LA1, LA2, LA3, and LA4. For example, the first color filter CF1 may be a blue color filter transmitting only the third light of the blue color and located to overlap the third emission area LA3. The second color filter CF2 may be a red color filter transmitting only the first light of the red color and located to overlap the first emission area LA1. The third color filter CF3 may be a green color filter transmitting only the second light of the green color and located to overlap the second emission area LA2 and the fourth emission area LA4.

As shown in FIG. 6, the first color filter CF1 may overlap the third emission area LA3 of each of the pixels PX1, PX2, PX3, and PX4, and may be located so as not to overlap the first emission area LA1, the second emission area LA2, and the fourth emission area LA4. For example, the first color filter CF1 may extend around the third emission area LA3 to be located adjacent to the first emission area LA1, the second emission area LA2, and the fourth emission area LA4. The first color filter CF1 may be located to surround the first emission area LA1 and may form a hole overlapping the first emission area LA1 to form or define the first light transmitting area OPT1. In addition, the first color filter CF1 may be located to surround the second emission area LA2 and the fourth emission area LA4, and may form a hole overlapping the second emission area LA2 to form or define the second light transmitting area OPT2 and may form a hole overlapping the fourth emission area LA4 to form or define the fourth light transmitting area OPT4.

As shown in FIG. 7, the second color filter CF2 may overlap the first emission area LA1 of each of the pixels PX1, PX2, PX3, and PX4, and may be located so as not to overlap the second emission area LA2, the third emission area LA3, and the fourth emission area LA4. For example, the second color filter CF2 may extend around the first emission area LA1 to be located adjacent to the second emission area LA2, the third emission area LA3, and the fourth emission area LA4. The second color filter CF2 may be located to surround the third emission area LA3 and may form a hole overlapping the third emission area LA3 to form the third light transmitting area OPT3. In addition, the second color filter CF2 may be located to surround the second emission area LA2 and the fourth emission area LA4, and may be located adjacent to the second light transmitting area OPT2 overlapping the second emission area LA2, and adjacent to the fourth light transmitting area OPT4 overlapping the fourth emission area LA4.

As shown in FIG. 8, the third color filter CF3 may overlap the second emission area LA2 and the fourth emission area LA4 of each of the pixels PX1, PX2, PX3, and PX4, and may be located so as not to overlap the first emission area LA1 and the third emission area LA3. For example, the third color filter CF3 may extend around the second emission area LA2 and the fourth emission area LA4 to be located adjacent to the first emission area LA1 and the third emission area LA3. The third color filter CF3 may be located to surround the first emission area LA1 and the third emission area LA3, and may be located adjacent to the first light transmitting area OPT1 overlapping the first emission area LA1, and adjacent to the third light transmitting area OPT3 overlapping the third emission area LA3.

The region where the first to third color filters CF1, CF2, and CF3 overlap in the thickness direction (e.g., the third direction DR3) may be formed as the light blocking area BMA. For example, in the periphery of the first light transmitting area OPT1 overlapping the first emission area LA1, a region where the first color filter CF1 overlaps the second color filter CF2 may be formed as the light blocking area BMA. In the periphery of the second light transmitting area OPT2 overlapping the second emission area LA2 and the fourth light transmitting area OPT4 overlapping the fourth emission area LA4, a region where the first color filter CF1 overlaps the third color filter CF3 may be formed as the light blocking area BMA. In the periphery of the third light transmitting area OPT3 overlapping the third emission area LA3, a region where the first color filter CF1 overlaps the second color filter CF2 may be formed as the light blocking area BMA.

The display device 10 may include the color filters CF1, CF2, and CF3 located on the display layer DU to reduce the intensity of reflected light caused by external light. In addition, the display device 10 may form a light blocking member by overlapping at least two color filters CF1, CF2, and CF3 in the thickness direction (e.g., the third direction DR3), without separately providing a layer for blocking light such as a black matrix. Accordingly, the process of forming a separate light blocking member may be omitted, thereby reducing manufacturing cost and simplifying the structure.

A touch electrode TL may be located between the emission areas LA1, LA2, LA3, and LA4. The touch electrode TL may be located to extend in the fourth direction DR4 and the fifth direction DR5, and may be spaced (e.g., spaced apart) from the emission areas LA1, LA2, LA3, and LA4. The touch electrode TL may be located to overlap the pixel defining film PDL (see FIG. 11) and the light blocking area BMA. Although the touch electrode TL is briefly illustrated in the drawing, the touch electrode TL may include a touch driving electrode and a sensing electrode.

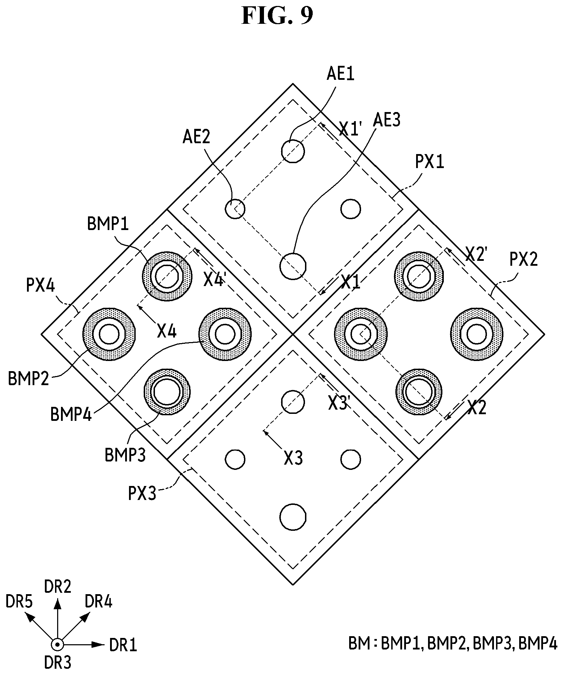

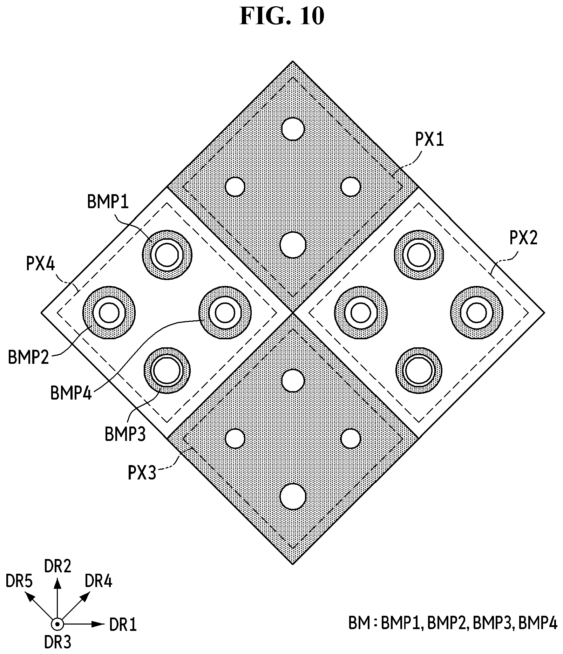

FIG. 9 is a plan view of the arrangement of emission areas and a light blocking layer in the display area of the display device according to one or more embodiments. FIG. 10 is a schematic diagram illustrating light emitting pixels according to an emission mode of the display device according to one or more embodiments. FIG. 9 schematically illustrates the light emitting pixels in an emission mode with partially restricted side visibility from among the emission modes of the display device 10.

Referring to FIGS. 9 and 10, the display device 10 according to one or more embodiments may include the light blocking layer BM. The light blocking layer BM may be located only in some of the plurality of pixels in the display area DA. For example, the light blocking layer BM may be located in the second type pixel, e.g., the second pixel PX2 and the fourth pixel PX4, of the plurality of pixels PX. As described above, the plurality of pixels PX may include two types of pixels with different separation distances between the emission areas LA1, LA2, LA3, and LA4 and the light transmitting areas OPT1, OPT2, OPT3, and OPT4, and the light blocking layer BM may be located only in the second type pixel.

The light blocking layer BM may include a plurality of light blocking patterns BMP1, BMP2, BMP3, and BMP4, and the light blocking patterns BMP1, BMP2, BMP3, and BMP4 may be located to correspond to the plurality of emission areas LA1, LA2, LA3, and LA4, respectively. For example, the light blocking patterns BMP1, BMP2, BMP3, and BMP4 may be located to be around (e.g., surround) the emission areas LA1, LA2, LA3, and LA4 in a plan view without overlapping the emission areas LA1, LA2, LA3, and LA4. The light blocking patterns BMP1, BMP2, BMP3, and BMP4 may have a circular ring shape surrounding the emission areas LA1, LA2, LA3, and LA4 without covering the emission areas in a plan view. Similarly to the light transmitting areas OPT1, OPT2, OPT3, and OPT4, the inner side surfaces of the light blocking patterns BMP1, BMP2, BMP3, and BMP4 may be spaced (e.g., spaced apart) from the outer side surfaces of the emission areas LA1, LA2, LA3, and LA4 in a plan view.

In the display device 10 according to one or more embodiments, the plurality of pixels PX1, PX2, PX3, and PX4 may include a first type pixel in which the light blocking layer BM is not located and a second type pixel in which the light blocking layer BM is located, thereby allowing the side visibility to be adjusted depending on the emission mode. The light blocking patterns BMP1, BMP2, BMP3, and BMP4 of the light blocking layer BM may block the path of light emitted from the emission areas LA1, LA2, LA3, and LA4 depending on the viewing angle of the display device 10. For example, light emitted from the front of the emission areas LA1, LA2, LA3, and LA4 may not be blocked by the light blocking patterns BMP1, BMP2, BMP3, and BMP4, but a portion of light emitted from the side of the emission areas LA1, LA2, LA3, and LA4 may be blocked by the light blocking patterns BMP1, BMP2, BMP3, and BMP4. That is, the light blocking patterns BMP1, BMP2, BMP3, and BMP4 may block the emission of light at a specific viewing angle.

For example, in a first emission mode of the display device 10, when the side visibility is not restricted, both the first type pixel and the second type pixel may emit light. For example, as shown in FIG. 9, when all of the first to fourth pixels PX1, PX2, PX3, and PX4 emit light in the first emission mode, light emitted from at least the first pixel PX1 and the third pixel PX3 may be visually recognized by the user, regardless of which direction the user looks at the display device 10.

On the other hand, in a second emission mode of the display device 10, when it is required to restrict the side visibility, only the second type pixel may emit light. For example, as illustrated in FIG. 10, when only the second pixel PX2 and the fourth pixel PX4 emit light in the second emission mode, light emitted from the light transmitting areas OPT1, OPT2, OPT3, and OPT4 may be blocked by the light blocking layer BM at a specific viewing angle. Because the first pixel PX1 and the third pixel PX3 do not emit light, the image on the screen of the display device 10 in the second emission mode may be visually recognized only by the user looking from the front of the display area DA, and may not be visually recognized by the user looking at a specific viewing angle or from the side. The display device 10 may provide a privacy protection mode to the user.

In the second emission mode of the display device 10, a light leakage phenomenon of light emitted from the emission areas LA1, LA2, LA3, and LA4 of the second pixel PX2 and the fourth pixel PX4 may occur depending on the extent to which they are covered by the light blocking layer BM. However, in the display device 10 according to one or more embodiments, the light blocking patterns BMP1, BMP2, BMP3, and BMP4 of the light blocking layer BM may be located to be around (e.g., to surround) the emission areas LA1, LA2, LA3, and LA4 in correspondence with the shapes of the emission areas. In the display device 10, the extent to which the emission areas LA1, LA2, LA3, and LA4 of the second type pixel are covered may be uniform at all viewing angles facing the display device 10 in the second emission mode, and a light leakage phenomenon of light emitted from the light emitting element including specific emission areas LA1, LA2, LA3, and LA4 may be reduced or prevented.

In addition, in the display device 10, as the light blocking patterns BMP1, BMP2, BMP3, and BMP4 of the light blocking layer BM are located to correspond to the emission areas LA1, LA2, LA3, and LA4 of the second type pixel, they may be located so as not to invade other adjacent pixels, e.g., the first type pixel, and therefore may not cover the emission areas LA1, LA2, LA3, and LA4 of the first type pixel in the first emission mode. That is, in the display device 10, the arrangement of the pixel structure may be freely designed even in the implementation of a high-resolution display device.

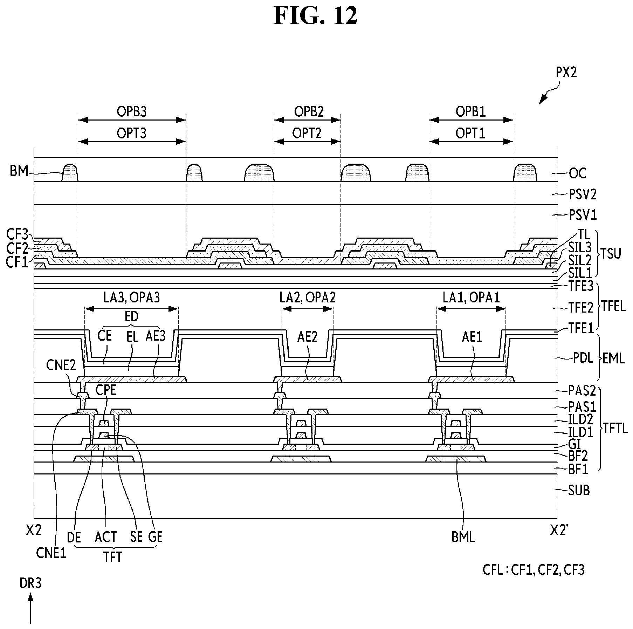

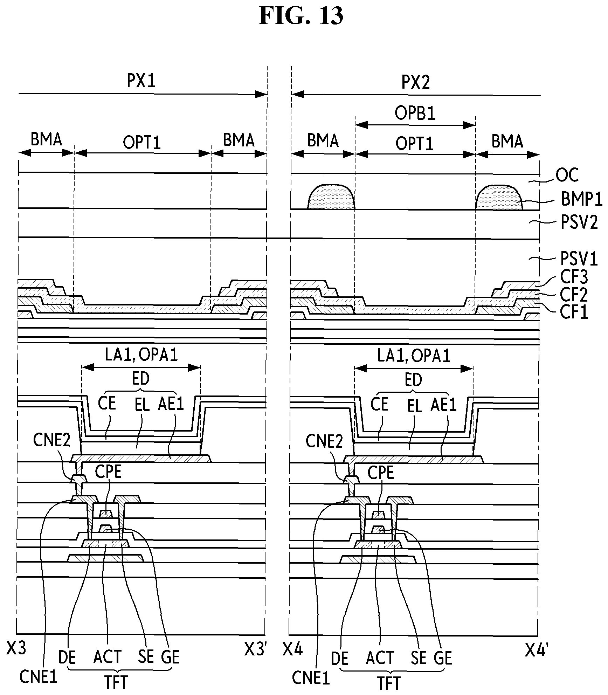

FIG. 11 is a cross-sectional view taken along the line X1-X1' of FIGS. 5 and 9. FIG. 12 is a cross-sectional view taken along the line X2-X2' of FIGS. 5 and 9. FIG. 13 is a cross-sectional view taken along the lines X3-X3' and X4-X4' of FIG. 9.

FIG. 11 shows a cross-section across the first to third emission areas LA1, LA2, and LA3 in the first pixel PX1, which is the first type pixel. FIG. 12 shows a cross-section across the first to third emission areas LA1, LA2, and LA3 in the second pixel PX2, which is the second type pixel. FIG. 13 shows a cross-section across the first emission area LA1 of the first type pixel and the first emission area LA1 of the second type pixel. A cross-sectional structure of the fourth emission area LA4 is the same as that of the second emission area LA2, and is therefore omitted in FIGS. 11 and 12.

A cross-sectional structure of the display device 10 will be described with reference to FIGS. 11 - 12. The display panel 100 of the display device 10 may include the display layer DU, the touch sensing layer TSU, the color filter layer CFL, and/or the light blocking layer BM. The display layer DU may include the substrate SUB, the thin film transistor layer TFTL, the light emitting element layer EML, and the encapsulation layer TFEL. The color filters CF1, CF2, and CF3 of the color filter layer CFL may be located on the touch sensing layer TSU of the display panel 100. The light blocking layer BM may be located on passivation layers PSV1 and PSV2 located on the color filter layer CFL, and an overcoat layer OC may be located on the light blocking layer BM.

The substrate SUB may be a base substrate or a base member. The substrate SUB may be a flexible substrate that can be bent, folded, and/or rolled. For example, the substrate SUB may include a polymer resin such as polyimide (PI), but is not limited thereto. For another example, the substrate SUB may include a glass material and/or a metal material.

The thin film transistor layer TFTL may include a first buffer layer BF1, a lower metal layer BML, a second buffer layer BF2, a thin film transistor TFT, a gate insulating layer GI, a first interlayer insulating layer ILD1, a capacitor electrode CPE, a second interlayer insulating layer ILD2, a first connection electrode CNE1, a first passivation layer PAS1, a second connection electrode CNE2, and a second passivation layer PAS2.

The first buffer layer BF1 may be located on the substrate SUB. The first buffer layer BF1 may include an inorganic film capable of preventing penetration of air and/or moisture. For example, the first buffer layer BF1 may include a plurality of inorganic films alternately stacked.

The lower metal layer BML may be located on the first buffer layer BF1. For example, the lower metal layer BML may be formed as a single layer or multiple layers made of molybdenum (Mo), aluminum (Al), chromium (Cr), gold (Au), titanium (Ti), nickel (Ni), neodymium (Nd) and/or copper (Cu), and/or an alloy thereof.

The second buffer layer BF2 may cover the first buffer layer BF1 and the lower metal layer BML. The second buffer layer BF2 may include an inorganic film capable of preventing penetration of air and/or moisture. For example, the second buffer layer BF2 may include a plurality of inorganic films alternately stacked.

The thin film transistor TFT may be located on the second buffer layer BF2, and may constitute a pixel circuit of each of a plurality of pixels. For example, the thin film transistor TFT may be a switching transistor or a driving transistor of the pixel circuit. The thin film transistor TFT may include a semiconductor layer ACT, a source electrode SE, a drain electrode DE, and a gate electrode GE.

The semiconductor layer ACT may be located on the second buffer layer BF2. The semiconductor layer ACT may overlap the lower metal layer BML and the gate electrode GE in the thickness direction (e.g., the third direction DR3), and may be insulated from the gate electrode GE by the gate insulating layer GI. In a portion of the semiconductor layer ACT, a material of the semiconductor layer ACT may be made into a conductor to form the source electrode SE and the drain electrode DE.

The gate electrode GE may be located on the gate insulating layer GI. The gate electrode GE may overlap the semiconductor layer ACT with the gate insulating layer GI interposed therebetween.

The gate insulating layer GI may be located on the semiconductor layer ACT. For example, the gate insulating layer GI may cover the semiconductor layer ACT and the second buffer layer BF2 to insulate the gate electrode GE from the semiconductor layer ACT. The gate insulating layer GI may include a plurality of contact holes, and the first contact electrode CNE1 may pass through a corresponding one of the contact holes.

The first interlayer insulating layer ILD1 may cover the gate electrode GE and the gate insulating layer GI. The first interlayer insulating layer ILD1 may include at least one contact hole through which the first connection electrode CNE1 passes. The contact hole of the first interlayer insulating layer ILD1 may be connected to the contact hole of the gate insulating layer GI and the contact hole of the second interlayer insulating layer ILD2.

The capacitor electrode CPE may be located on the first interlayer insulating layer ILD1. The capacitor electrode CPE may overlap the gate electrode GE in the thickness direction (e.g., the third direction DR3). The capacitor electrode CPE and the gate electrode GE may form a capacitance.

The second interlayer insulating layer ILD2 may cover the capacitor electrode CPE and the first interlayer insulating layer ILD1. The second interlayer insulating layer ILD2 may include at least one contact hole through which the first connection electrode CNE1 passes. The contact hole of the second interlayer insulating layer ILD2 may be connected to the contact hole of the first interlayer insulating layer ILD1 and the contact hole of the gate insulating layer GI.

The first connection electrode CNE1 may be located on the second interlayer insulating layer ILD2. The first connection electrode CNE1 may electrically connect the drain electrode DE of the thin film transistor TFT to the second connection electrode CNE2. The first connection electrode CNE1 may be inserted into a contact hole provided in the second interlayer insulating layer ILD2, the first interlayer insulating layer ILD1, and the gate insulating layer GI to be in contact with the drain electrode DE of the thin film transistor TFT. In one or more embodiments, the first connection electrode CNE1 may also be connected to the source electrode SE of the thin film transistor TFT.

The first passivation layer PAS1 may cover the first connection electrode CNE1 and the second interlayer insulating layer ILD2. The first passivation layer PAS1 may protect the thin film transistor TFT. The first passivation layer PAS1 may include a contact hole through which the second connection electrode CNE2 passes.

The second connection electrode CNE2 may be located on the first passivation layer PAS1. The second connection electrode CNE2 may electrically connect the first connection electrode CNE1 to a pixel electrode AE of the light emitting element ED. The second connection electrode CNE2 may be inserted into a contact hole formed in the first passivation layer PAS1 to be in contact with the first connection electrode CNE1.

The second passivation layer PAS2 may cover the second connection electrode CNE2 and the first passivation layer PAS1. The second passivation layer PAS2 may include a contact hole through which the pixel electrode AE of the light emitting element ED passes.

The light emitting element layer EML may be located on the thin film transistor layer TFTL. The light emitting element layer EML may include the light emitting element ED and the pixel defining film PDL. The light emitting element ED may include the pixel electrodes AE1, AE2, and AE3, a light emitting layer EL, and a common electrode CE.

The pixel electrodes AE1, AE2, and AE3 may be located on the second passivation layer PAS2. The different pixel electrodes AE1, AE2, and AE3 may each be located to overlap one (e.g., a corresponding one) of the different openings of the pixel defining film PDL. The pixel electrodes AE1, AE2, and AE3 may be electrically connected to the drain electrode DE of the thin film transistor TFT through the first and second connection electrodes CNE1 and CNE2.

The light emitting layer EL may be located on the pixel electrodes AE1, AE2, and AE3. For example, the light emitting layer EL may be an organic light emitting layer made of an organic material, but is not limited thereto. In the case of employing the organic light emitting layer as the light emitting layer EL, the thin film transistor TFT applies a suitable voltage (e.g., a predetermined voltage) to the pixel electrodes AE1, AE2, and AE3 of the light emitting element ED, and if the common electrode CE of the light emitting element ED receives a common voltage or a cathode voltage, the holes and electrons can move to the light emitting layer EL through the hole transporting layer and the electron transporting layer and combine to produce light to be emitted by the light emitting layer EL.

In one or more embodiments, the light emitting layers EL located on different pixel electrodes AE1, AE2, and AE3 may emit light of different colors. For example, the light emitting layer EL located on the first pixel electrode AE1 may emit red light of the first color, the light emitting layer EL located on the second pixel electrode AE2 may emit green light of the second color, and the light emitting layer EL located on the third pixel electrode AE3 may emit blue light of the third color. However, the present invention is not limited thereto. In another embodiment, the light emitting layer EL may be located as a single common layer on the different pixel electrodes AE1, AE2, and AE3 and the pixel defining film PDL, and the light emitting layer EL located on the different pixel electrodes AE1, AE2, and AE3 may emit light of the same color. In this case, the display device 10 may further include a color adjustment layer located on the light emitting elements ED.

The common electrode CE may be located on the light emitting layer EL. For example, the common electrode CE may be made in the form of an electrode common to all of the pixels rather than specific to each of the pixels. The common electrode CE may be located on the light emitting layer EL in the first to third pixel electrodes AE1, AE2, and AE3, and may be located on the pixel defining film PDL in an area other than the first to third pixel electrodes AE1, AE2, and AE3.

The common electrode CE may receive the common voltage or a low potential voltage. When the pixel electrode AE receives a voltage corresponding to a data voltage and the common electrode CE receives the low potential voltage, a potential difference is formed between the pixel electrodes AE1, AE2, and AE3 and the common electrode CE, so that the light emitting layer EL may emit light.

The pixel defining film PDL may include a plurality of openings and may be located on a portion of the pixel electrodes AE1, AE2, and AE3 and the second passivation layer PAS2. Each opening of the pixel defining film PDL may expose a portion of the pixel electrodes AE1, AE2, and AE3. As described above, the respective openings of the pixel defining film PDL may define the first to third emission areas, and the areas or sizes thereof may be different from each other. The pixel defining film PDL may separate and insulate the pixel electrodes AE1, AE2, and AE3 of each of the plurality of light emitting elements ED. The pixel defining film PDL may include a light absorbing material to prevent light reflection. For example, the pixel defining film PDL may include a polyimide (PI)-based binder and a pigment in which red, green, and blue colors are mixed. Alternatively, the pixel defining film PDL may include a cardo-based binder resin and a mixture of a lactam black pigment and/or a blue pigment. Alternatively, the pixel defining film PDL may include carbon black.

The encapsulation layer TFEL may be located on the common electrode CE to cover the plurality of light emitting elements ED. The encapsulation layer TFEL may include at least one inorganic film to prevent oxygen and/or moisture from penetrating into the light emitting element layer EML. The encapsulation layer TFEL may include at least one organic film to protect the light emitting element layer EML from foreign matters such as dust.

In one or more embodiments, the encapsulation layer TFEL may include a first encapsulation layer TFE1, a second encapsulation layer TFE2, and a third encapsulation layer TFE3. The first encapsulation layer TFE1 and the third encapsulation layer TFE3 may be inorganic encapsulation layers, and the second encapsulation layer TFE2 located between the first encapsulation layer TFE1 and the third encapsulation layer TFE3 may be an organic encapsulation layer.

Each of the first encapsulation layer TFE1 and the third encapsulation layer TFE3 may include one or more inorganic insulating materials. The inorganic insulating material may include aluminum oxide, titanium oxide, tantalum oxide, hafnium oxide, zinc oxide, silicon oxide, silicon nitride, and/or silicon oxynitride.

The second encapsulation layer TFE2 may include a polymer-based material. Examples of the polymer-based material may include acrylic resin, epoxy resin, polyimide, polyethylene, and/or the like. For example, the second encapsulation layer TFE2 may include an acrylic resin, for example, polymethyl methacrylate, polyacrylic acid, and/or the like. The second encapsulation layer TFE2 may be formed by curing a monomer or applying a polymer.

The touch sensing layer TSU may be located on the encapsulation layer TFEL. The touch sensing layer TSU may include a first touch insulating layer SIL1, a second touch insulating layer SIL2, the touch electrode TL, and a third touch insulating layer SIL3.

The first touch insulating layer SIL1 may be located on the encapsulation layer TFEL. The first touch insulating layer SIL1 may have an insulating and optical function. The first touch insulating layer SIL1 may include at least one inorganic film. Optionally, the first touch insulating layer SIL1 may be omitted.

The second touch insulating layer SIL2 may cover the first touch insulating layer SIL1. In one or more embodiments, a touch electrode of another layer may be further located on the first touch insulating layer SIL1, and the second touch insulating layer SIL2 may cover the touch electrode TL. The second touch insulating layer SIL2 may have an insulating and optical function. For example, the second touch insulating layer SIL2 may be an inorganic film containing at least one of a silicon nitride layer, a silicon oxynitride layer, a silicon oxide layer, a titanium oxide layer, and/or an aluminum oxide layer.

A portion of the touch electrode TL may be located on the second touch insulating layer SIL2. The touch electrode TL may not overlap the first to third pixel electrodes AE1, AE2, and AE3. The touch electrode TL may be formed as a single layer containing molybdenum (Mo), titanium (Ti), copper (Cu), aluminum (Al), and/or indium tin oxide (ITO), or may be formed to have a stacked structure (Ti/Al/Ti) of aluminum and titanium, a stacked structure (ITO/Al/ITO) of aluminum and ITO, an Ag-Pd-Cu (APC) alloy, or a stacked structure (ITO/APC/ITO) of APC alloy and ITO.

The touch electrode TL of the touch sensing layer TSU may have a constant line width and may be located to overlap the light blocking area BMA of the color filter layer CFL, which will be described later. The light blocking area BMA of the color filter layer CFL may have a width sufficient to completely cover the touch electrode TL, and a gap between the touch electrode TL and the edge of the light blocking area BMA of the color filter layer CFL may be defined. In one or more embodiments, the line width of the touch electrode TL may be in a range of 4 $\mu$m to 6 $\mu$m, and the gap between the touch electrode TL and the edge of the light blocking area BMA of the color filter layer CFL may be in a range of 5 $\mu$m to 7 $\mu$m. The

touch electrode TL may be located such that its center is substantially aligned with the center of the light blocking area BMA of the color filter layer CFL, and the gap from both sides of the touch electrode TL to the edge of the light blocking area BMA of the color filter layer CFL may be substantially constant.

The third touch insulating layer SIL3 may cover the touch electrode TL and the second touch insulating layer SIL2. The third touch insulating layer SIL3 may have an insulating and optical function. The third touch insulating layer SIL3 may be made of the material disclosed as an example in association with the second touch insulating layer SIL2.

The color filters CF1, CF2, and CF3 of the color filter layer CFL may be located on the third touch insulating layer SIL3 of the touch sensing layer TSU. The different color filters CF1, CF2, and CF3 may be located to correspond to the different emission areas LA1, LA2, and LA3, respectively. For example, the first color filter CF1 may be located to correspond to the third emission area LA3, the second color filter CF2 may be located to correspond to the first emission area LA1, and the third color filter CF3 may be located to correspond to the second emission area LA2 and the fourth emission area LA4. As described above, the first color filter CF1 may form the first light transmitting area OPT1 and the second light transmitting area OPT2, and the second color filter CF2 may form the third light transmitting area OPT3. In addition, the first color filter CF1 and the second color filter CF2 may overlap in the thickness direction (e.g., the third direction DR3), and the first color filter CF1 and the third color filter CF3 may overlap in the thickness direction (e.g., the third direction DR3) to form the light blocking area BMA. Also, the first color filter CF1, the second color filter, and the third color filter CF3 may overlap in the thickness direction (e.g., the third direction DR3) to form the light blocking area BMA.

The light blocking area BMA may be located to cover the conductive line of the touch electrode TL, and may be located to overlap the pixel defining film PDL. The plurality of light transmitting areas OPT1, OPT2, and OPT3 may overlap the emission areas LA1, LA2, and LA3 of the first and second pixels PX1 and PX2. For example, the first light transmitting area OPT1 may be located to overlap the first emission area LA1 of the first pixel PX1. The second light transmitting area OPT2 may be located to overlap the second emission area LA2 of the first pixel PX1, and the third light transmitting area OPT3 may be located to overlap the third emission area LA3 of the first pixel PX1. The areas or sizes of the light transmitting areas OPT1, OPT2, and OPT3 may be larger than the areas or sizes of the emission areas LA1, LA2, and LA3. In addition, the light transmitting areas OPT1, OPT2, and OPT3 are formed to be larger in area or size than the openings OPA1, OPA2, and OPA3 of the pixel defining film PDL, so that the light emitted from the light emitting element ED may be visually recognized by the user not only from the front but also from the side of the display device 10. However, whether or not the first pixel PX1 and the second pixel PX2 emit light may vary depending on the emission mode of the display device 10, and the shape of the light blocking area BMA may be designed such that light is not visually recognized at a specific viewing angle in the emission mode in which side visibility is restricted in the second pixel PX2 (and/or the fourth pixel PX4).

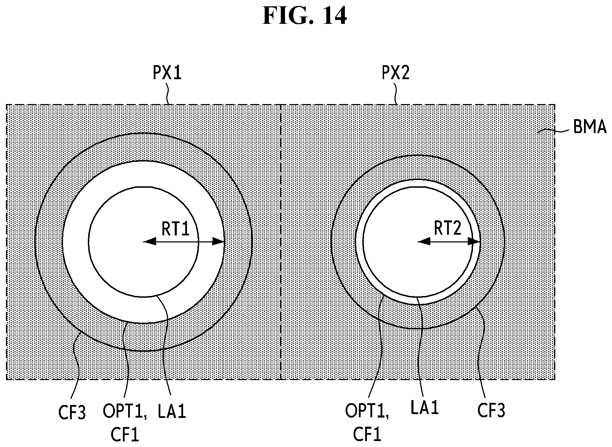

FIG. 14 is a diagram illustrating the relative arrangement of an emission area and a light blocking area located in one pixel of the display device according to one embodiment. FIG. 14 exemplarily shows the first emission area LA1 among the emission areas LA1, LA2, LA3, and LA4 of each of the first pixel PX1 and the second pixel PX2.

Referring to FIG. 14, in the display device 10 according to one or more embodiments, the size of the first light transmitting area OPT1 located in the first pixel PX1 may be larger than the size of the first light transmitting area OPT1 located in the second pixel PX2. For example, a radius RT1, or the size of the first light transmitting area OPT1 overlapping the first emission area LA1 of the first pixel PX1 may be larger than a radius RT2, or the size of the first light transmitting area OPT1 overlapping the first emission area LA1 of the second pixel PX2.

In the second emission mode of the display device 10, the first type pixel may not emit light, and only the second type pixel may emit light. When the second type pixel emits light, the sizes of the light transmitting areas OPT1, OPT2, OPT3, and OPT4 of the color filter layer CFL in the second pixel PX2 may be relatively small so as to block light emission at a specific viewing angle. Further, because the light blocking layer BM is located in the second type pixel, the second emission mode of the display device 10 may control the side visibility of light emitted from the second type pixel.

In the first emission mode, both the first pixel PX1 and the second pixel PX2 emit light and may be visually recognized from the front and the side. Accordingly, in the first pixel PX1, in order to ensure visibility from the side, the diameters of the emission areas LA1, LA2, LA3, and LA4 and the light transmitting areas OPT1, OPT2, OPT3, and OPT4 may be larger than or equal to a certain level. In contrast, in the second emission mode, the first pixel PX1 may not emit light, and light of the second pixel PX2 may not be visually recognized at a side viewing angle except for a viewing angle close to the front in the second emission mode. The diameters of the light transmitting areas OPT1, OPT2, OPT3, and OPT4 located in the second pixel PX2 may not be substantially different from the diameters of the emission areas LA1, LA2, LA3, and LA4, and visibility may be restricted even at a small side viewing angle. In addition, the light blocking layer BM, which will be described later, may be provided in the second pixel PX2 to further restrict the side visibility.

In the display device 10, the emission areas LA1, LA2, LA3, and LA4 of the same type located in the first pixel PX1 and the second pixel PX2, for example, the first emission area LA1 of the first pixel PX1 and the first emission area LA1 of the second pixel PX2, may have the same diameter, and the first light transmitting area OPT1 located in the first pixel PX1 may have a larger diameter than the first light transmitting area OPT1 located in the second pixel PX2. In one or more embodiments, the diameter differences between the light transmitting areas OPT1, OPT2, OPT3, and OPT4 and the emission areas LA1, LA2, LA3, and LA4 in the second pixel PX2 may be from 1.0 $\mu$m to 3 $\mu$m, or approximately 2 $\mu$m, and the diameter differences between the light transmitting areas OPT1, OPT2, OPT3, and OPT4 and the emission areas LA1, LA2, LA3, and LA4 in the first pixel PX1 may be from 4 $\mu$m to 7 $\mu$m, or approximately 5 $\mu$m.

The differences between the diameters of the light transmitting areas OPT1, OPT2, OPT3, and OPT4 of the first pixel PX1 and the diameters of the light transmitting areas OPT1, OPT2, OPT3, and OPT4 of the second pixel PX2 may be values designed in consideration of an optical distance, e.g., a distance from the pixel electrodes of the emission areas LA1, LA2, LA3, and LA4 to the top surface of the second encapsulation layer TFE2. However, the present invention is not limited thereto, and the difference in diameter between the holes located in the first pixel PX1 and the second pixel PX2 may be designed and modified in various ways according to optical characteristic conditions that are necessary for the electronic device 1, or required for the electronic device 1.

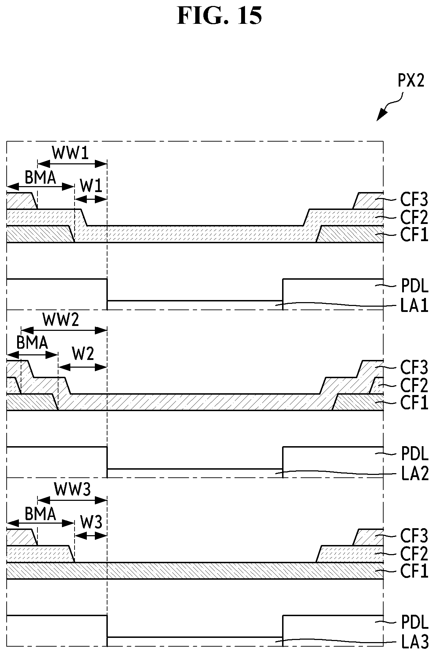

FIG. 15 is a diagram illustrating the relative arrangement of an emission area and color filters located in one pixel of the display device according to one or more embodiments. FIG. 15 shows an example of the first to third emission areas LA1, LA2, and LA3 of the second pixel PX2.

Referring to FIG. 15, the display device 10 according to one or more embodiments may include the first color filter CF1, the second color filter CF2, and the third color filter CF3. The thickness of the first color filter CF1 may be smaller than the thickness of the second color filter CF2 and larger than the thickness of the third color filter CF3. The thickness of the second color filter CF2 may be larger than the thickness of the first color filter CF1 and the thickness of the third color filter CF3. In one or more embodiments, the thickness of each of the first color filter CF1, the second color filter CF2, and the third color filter CF3 may range from 1 $\mu$m to 4 $\mu$m. However, in one or more embodiments, thickness of the first color filter CF1, the second color filter CF2, and the third color filter CF3 may be substantially the same.

The distances between the light blocking area BMA and the emission areas LA1, LA2, and LA3 located in the second pixel PX2 may be different from each other. For example, a distance W1 between the first emission area LA1 and the light blocking area BMA may be smaller than a distance W2 between the second emission area LA2 and the light blocking area BMA, and a distance W3 between the third emission area LA3 and the light blocking area BMA. The distance W2 between the second emission area LA2 and the light blocking area BMA may be larger than the distance W1 between the first emission area LA1 and the light blocking area BMA, and the distance W3 between the third emission area LA3 and the light blocking area BMA. In one or more embodiments, the distance W1 between the first emission area LA1 and the light blocking area BMA, the distance W2 between the second emission area LA2 and the light blocking area BMA, and the distance W3 between the third emission area LA3 and the light blocking area BMA may range from 2 $\mu$m to 3 $\mu$m.

In addition, a distance WW1 between the first emission area LA1 and the third color filter CF3, a distance WW2 between the second emission area LA2 and the second color filter CF2, and a distance WW3 between the third emission area LA3 and the third color filter CF3 may be different from each other. For example, the distance WW1 between the first emission area LA1 and the third color filter CF3 may be smaller than the distance WW2 between the second emission area LA2 and the second color filter CF2, and larger than the distance WW3 between the third emission area LA3 and the third color filter CF3. The distance WW2 between the second emission area LA2 and the second color filter CF2 may be larger than the distance WW1 between the first emission area LA1 and the third color filter CF3, and the distance WW3 between the third emission area LA3 and the third color filter CF3. In one or more embodiments, the distance WW1 between the first emission area LA1 and the third color filter CF3, the distance WW2 between the second emission area LA2 and the second color filter CF2, and the distance WW3 between the third emission area LA3 and the third color filter CF3 may each range from 3 $\mu$m to 4 $\mu$m. In addition, the distance between one end of the first color filter CF1 and one end of the third color filter CF3 in the first emission area LA1 may be the same as the distance between one end of the first color filter CF1 and one end of the second color filter CF2 in the second emission area LA2, and the distance between one end of the second color filter CF2 and one end of the third color filter CF3 in the third emission area LA3.

The light blocking area BMA may be a region where the first color filter CF1 and the second color filter CF2 overlap in the thickness direction (e.g., the third direction DR3), or a region where the first color filter CF1 and the third color filter CF3 overlap in the thickness direction (e.g., the third direction DR3). For example, the light blocking area BMA adjacent to the first emission area LA1 and the third emission area LA3 may be a region where the first color filter CF1 and the second color filter CF2 overlap, and the light blocking area BMA adjacent to the second emission area LA2 may be a region where the first color filter CF1 and the third color filter CF3 overlap. Accordingly, the distance W1 between the first emission area LA1 and the light blocking area BMA may be the distance between the first emission area LA1 and the first color filter CF1, the distance W2 between the second emission area LA2 and the light blocking area BMA may be the distance between the second emission area LA2 and the first color filter CF1, and the distance W3 between the third emission area LA3 and the light blocking area BMA may be the distance between the third emission area LA3 and the second color filter CF2.

Referring to FIGS. 11 and 12, the passivation layers PSV1 and PSV2 may be located on the color filter layer CFL. The passivation layers PSV1 and PSV2 may be located over the entire display area DA to flatten the top surface of the display panel 100. The passivation layers PSV1 and PSV2 may include a first passivation layer PSV1 located on the color filter layer CFL, and a second passivation layer PSV2 located on the first passivation layer PSV1. The passivation layers PSV1 and PSV2 may be formed as a plurality of layers and flatten the stepped portion caused by the color filter layer CFL.

The passivation layers PSV1 and PSV2 may be a colorless light transmissive layer that does not have a color in a visible light band. For example, the passivation layers PSV1 and PSV2 may include a colorless light transmissive organic material such as an acrylic resin. In another embodiment, a third passivation layer may be further included between the second passivation layer PSV2 and the light blocking layer BM. The third passivation layer may contain a transmissive inorganic material. For example, the transmissive inorganic material may include aluminum oxide, titanium oxide, tantalum oxide, hafnium oxide, zinc oxide, silicon oxide, silicon nitride, and/or silicon oxynitride.

The light blocking layer BM may be located on the passivation layers PSV1 and PSV2. The light blocking layer BM may not be located in the first type pixel (or the first pixel PX1), but may be located only in the second type pixel (or the second pixel PX2). The light blocking layer BM may be located to correspond to the periphery of the emission areas LA1, LA2, and LA3 of the second type pixel, and may form light output portions OPB1, OPB2, and OPB3 that overlap the emission areas LA1, LA2, and LA3. For example, the light blocking layer BM may include a first light output portion OPB1 overlapping the first emission area LA1, a second light output portion OPB2 overlapping the second emission area LA2, and a third light output portion OPB3 overlapping the third emission area LA3. The light output portions OPB1, OPB2, and OPB3 may overlap the light transmitting areas OPT1, OPT2, and OPT3 of the color filter layer CFL, respectively.

In one or more embodiments, the diameters or areas of the light output portions OPB1, OPB2, and OPB3 of the light blocking layer BM in a plan view may be the same as the diameters or areas of the light transmitting areas OPT1, OPT2, and OPT3 of the color filter layer CFL in a plan view, and may be larger than the diameters or areas of the emission areas LA1, LA2, and LA3 in a plan view. For example, the inner side surfaces of the light output portions OPB1, OPB2, and OPB3 of the light blocking layer BM may be aligned and matched with the inner side surfaces of the light transmitting areas OPT1, OPT2, and OPT3 of the color filter layer CFL. In the off state of the display device 10, visibility due to reflective characteristics of external light exists. The visibility of the display device 10 in the off state may vary depending on the overlapping region of the color filters CF1, CF2, and CF3. For example, the visibility may differ between the region where the first color filter CF1 and the second color filter CF2 overlap and the region where the first color filter CF1 and the third color filter CF3 overlap. In this embodiment, in order to eliminate such difference in visibility, the light blocking layer BM may be located to overlap the region where the color filters CF1, CF2, and CF3 overlap. That is, by disposing the inner side surfaces of the light output portions OPB1, OPB2, and OPB3 of the light blocking layer BM to be aligned and matched with the inner side surfaces of the light transmitting areas OPT1, OPT2, and OPT3 of the color filter layer CFL, the visibility of the display device 10 in the off state may be improved.

The light emitted from the light emitting element ED of the emission areas LA1, LA2, and LA3 may be outputted through the light transmitting areas OPT1, OPT2, and OPT3 of the color filter layer CFL and the light output portions OPB1, OPB2, and OPB3 of the light blocking layer BM. The light emitted from the second type pixel is finally emitted after passing through the light output portions OPB1, OPB2, and OPB3, and a lot of light may be visually recognized at least when the display device 10 is viewed from the front.

However, when the display device 10 is viewed from the side, the light emitted from the second type pixel may be blocked by the light blocking layer BM although the light passes through the light transmitting areas OPT1, OPT2, and OPT3 of the color filter layer CFL. In other words, the display device 10 may allow only the second pixel PX2 or the second type pixel in which the light blocking layer BM is located to emit light in the second emission mode, thereby controlling visibility at a specific viewing angle and providing a privacy protection mode to the user.

The light blocking layer BM may include a light absorbing material. For example, the light blocking layer BM may include an inorganic black pigment and/or an organic black pigment. The inorganic black pigment may be carbon black, and the organic black pigment may include lactam black, perylene black, and/or aniline black, but they are not limited thereto. In one or more embodiments, the light blocking layer BM may have a thickness of 1 $\mu$m to 3 $\mu$m, or approximately 1.5 $\mu$m.

The overcoat layer OC may be located on the light blocking layer BM and the passivation layers PSV1 and PSV2. The overcoat layer OC may be located over the entire display area DA to flatten the top surface of the display panel 100. The overcoat layer OC may be a colorless light transmissive layer that does not have a color in a visible light band. For example, the overcoat layer OC may include a colorless light transmissive organic material such as an acrylic resin.

Hereinafter, the light blocking layer BM and the emission areas LA1, LA2, LA3, and LA4 of the display device 10 will be described in more detail with reference to other drawings.

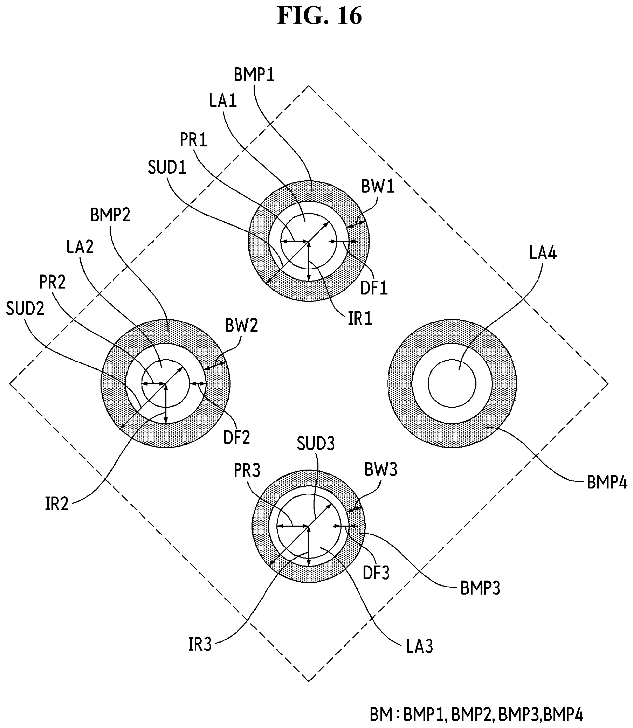

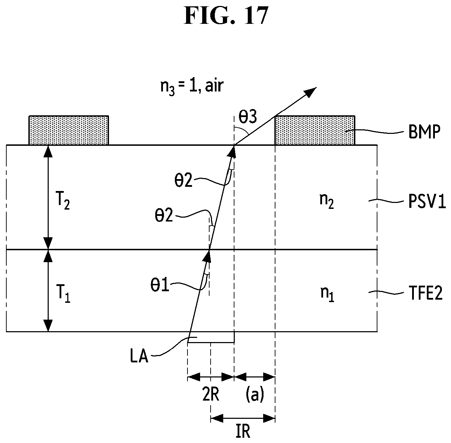

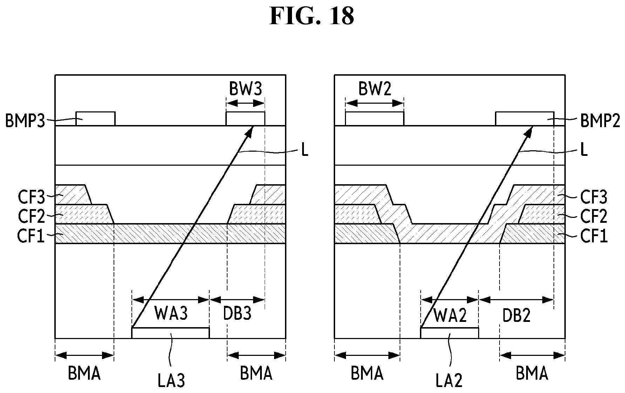

FIG. 16 is a diagram illustrating the relative arrangement of an emission area and a light blocking layer located in the second type pixel of the display device according to one or more embodiments. FIG. 17 is a schematic diagram illustrating the relative arrangement of an emission area and a light blocking layer located in the second type pixel of the display device according to one or more embodiments. FIG. 18 is an diagram illustrating an emission direction of light emitted from an emission area of a display device and a relative arrangement of a light blocking layer. FIG. 16 illustrates an example of the second type pixel, or the second pixel PX2, in which the light blocking layer BM is located. FIG. 17 is a diagram illustrating an equation for calculating the difference between the inner radius of a light blocking pattern and the radius of an emission area. FIG. 18 illustrates the size variation of the light blocking patterns BMP2 and BMP3 according to the emission areas LA2 and LA3 having different diameters. Hereinafter, the fourth emission area LA4 and a fourth light blocking pattern BMP4 have the same configuration as the second emission area LA2 and a second light blocking pattern BMP2, and thus a description thereof will be omitted.

Referring to FIGS. 16 and 17, in the display device 10, radii PR1, PR2, and PR3 of the different emission areas LA1, LA2, and LA3 may be different from each other. For example, the radius PR3 of the third emission area LA3 may be larger than the radii PR1 and PR2 of the first emission area LA1 and the second emission area LA2. The radius PR1 of the first emission area LA1 may be larger than the radius PR2 of the second emission area LA2. This may be because the surface areas of the emission areas LA1, LA2, and LA3 are designed in consideration of the wavelength of light emitted from the light emitting element ED and the lifespan of the light emitting element ED in each of the emission areas LA1, LA2, and LA3.

In one or more embodiments, as described above, in the display device 10, the emission areas LA1, LA2, and LA3 of the same type located in each of the first pixel PX1 and the second pixel PX2 may have the same diameter. For example, the first emission area LA1 located in the first pixel PX1 may have the same diameter as the first emission area LA1 located in the second pixel PX2.

The light blocking layer BM may include the light blocking patterns BMP1, BMP2, BMP3, and BMP4, which correspond to the respective emission areas LA1, LA2, LA3, and LA4 in the second pixel PX2 and surround the emission areas LA1, LA2, LA3, and LA4 in a plan view. For example, the light blocking layer BM may include a first light blocking pattern BMP1 surrounding the first emission area LA1, the second light blocking pattern BMP2 surrounding the second emission area LA2, a third light blocking pattern BMP3 surrounding the third emission area LA3, and the fourth light blocking pattern BMP4 surrounding the fourth emission area LA4. Hereinafter, because the fourth emission area LA4 and the fourth light blocking pattern BMP4 have the same configuration as the second emission area LA2 and the second light blocking pattern BMP2, a description thereof will be omitted.

The plurality of light blocking patterns BMP1, BMP2, and BMP3 of the light blocking layer BM may form the light output portions OPB1, OPB2, and OPB3 (see FIG. 12) overlapping the emission areas LA1, LA2, and LA3, may have a circular ring shape, and may have inner radii IR1, IR2, and IR3 measured from the centers of the emission areas LA1, LA2, and LA3 and widths BW1, BW2, and BW3 of the light blocking patterns BMP1, BMP2, and BMP3 themselves.

According to one or more embodiments, the plurality of light blocking patterns BMP1, BMP2, and BMP3 of the light blocking layer BM may have different inner radii IR1, IR2, and IR3. For example, the inner radius IR3 of the third light blocking pattern BMP3 may be larger than the inner radius IR1 of the first light blocking pattern BMP1 and the inner radius IR2 of the second light blocking pattern BMP2. The inner radius IR1 of the first light blocking pattern BMP1 may be larger than the inner radius IR2 of the second light blocking pattern BMP2.

In addition, differences DF1, DF2, and DF3 between the inner radii IR1, IR2, and IR3 of the respective light blocking patterns BMP1, BMP2, and BMP3 and the radii PR1, PR2, and PR3 of the emission areas LA1, LA2, and LA3 may be different from each other. For example, the difference DF3 between the inner radius IR3 of the third light blocking pattern BMP3 and the radius PR3 of the third emission area LA3 may be larger than the difference DF1 between the inner radius IR1 of the first light blocking pattern BMP1 and the radius PR1 of the first emission area LA1, and smaller than the difference DF2 between the inner radius IR2 of the second light blocking pattern BMP2 and the radius PR2 of the second emission area LA2. The difference DF1 between the inner radius IR1 of the first light blocking pattern BMP1 and the radius PR1 of the first emission area LA1 may be smaller than the difference DF2 between the inner radius IR2 of the second light blocking pattern BMP2 and the radius PR2 of the second emission area LA2, and smaller than the difference DF3 between the inner radius IR3 of the third light blocking pattern BMP3 and the radius PR3 of the third emission area LA3. The difference DF2 between the inner radius IR2 of the second light blocking pattern BMP2 and the radius PR2 of the second emission area LA2 may be larger than the difference DF1 between the inner radius IR1 of the first light blocking pattern BMP1 and the radius PR1 of the first emission area LA1 and the difference DF3 between the inner radius IR3 of the third light blocking pattern BMP3 and the radius PR3 of the third emission area LA3. In one or more embodiments, the inner radii IR1, IR2, and IR3 of the light blocking patterns BMP1, BMP2, and BMP3 may each have a size of approximately 10 μm, and the differences between the inner radii IR1, IR2, and IR3 of the light blocking patterns BMP1, BMP2, and BMP3 and the radii PR1, PR2, and PR3 of the emission areas LA1, LA2, and LA3 may range from 2 μm to 3 μm.

The widths BW1, BW2, and BW3 of the light blocking patterns BMP1, BMP2, and BMP3 may be different from each other. The widths BW1, BW2, and BW3 of the respective light blocking patterns BMP1, BMP2, and BMP3 may be related to the radii of the corresponding emission areas LA1, LA2, and LA3. In one or more embodiments, the size relationship between the widths BW1, BW2, and BW3 of the light blocking patterns BMP1, BMP2, and BMP3 in the display device 10 may be opposite to the size relationship between the radii PR1, PR2, and PR3 of the emission areas LA1, LA2, and LA3. For example, the radius PR3 of the third emission area LA3 may be larger than the radius PR1 of the first emission area LA1 and the radius PR2 of the second emission area LA2, but the width BW3 of the third light blocking pattern BMP3 may be smaller than the width BW1 of the first light blocking pattern BMP1 and the width BW2 of the second light blocking pattern BMP2. The radius PR2 of the second emission area LA2 may be smaller than the radius PR1 of the first emission area LA1, but the width BW2 of the second light blocking pattern BMP2 may be larger than the width BW1 of the first light blocking pattern BMP1. The sizes of the radii PR1, PR2, and PR3 of the emission areas LA1, LA2, and LA3 may decrease in the order of the radius PR3 of the third emission area LA3, the radius PR1 of the first emission area LA1, and the radius PR2 of the second emission area LA2, but the sizes of the light blocking patterns BMP1, BMP2, and BMP3 may increase in the order of the third light blocking pattern BMP3, the first light blocking pattern BMP1, and the second light blocking pattern BMP2. In one or more embodiments, the widths BW1, BW2, and BW3 of the light blocking patterns BMP1, BMP2, and BMP3 may range from 7 μm to 9 μm.

In addition, sums SUD1, SUD2, and SUD3 of the diameters (radius × 2) of the respective emission areas LA1, LA2, and LA3, the differences between the radii PR1, PR2, and PR3 of the respective emission areas LA1, LA2, and LA3 and the inner radii IR1, IR2, and IR3 of the respective light blocking patterns BMP1, BMP2, and BMP3, and the widths BW1, BW2, and BW3 of the respective light blocking patterns BMP1, BMP2, AND BMP3 may be the same. For example, the sum SUD1 of the diameter (PR1 × 2) of the first emission area LA1, the difference DF1 between the radius PR1 of the first emission area LA1 and the inner radius IR1 of the first light blocking pattern BMP1, and the width BW1 of the first light blocking pattern BMP1 may be equal to the sum SUD2 of the diameter (PR2 × 2) of the second emission area LA2, the difference DF2 between the radius PR2 of the second emission area LA2 and the inner radius IR2 of the second light blocking pattern BMP2, and the width BW2 of the second light blocking pattern BMP2, and also equal to the sum SUD3 of the diameter (PR3 × 2) of the third emission area LA3, the difference DF3 between the radius PR3 of the third emission area LA3 and the inner radius IR3 of the third light blocking pattern BMP3, and the width BW3 of the third light blocking pattern BMP3.

The extent to which the emission areas LA1, LA2, and LA3 are covered by the light blocking patterns BMP1, BMP2, and BMP3 at a specific viewing angle looking at the display device 10 may be correlated with the separation distances (or gaps) between the emission areas LA1, LA2, and LA3 and the light blocking patterns BMP1, BMP2, and BMP3. In order for light not to be visually recognized when the display device 10 in the second emission mode is viewed from a specific viewing angle, all of the emission areas LA1, LA2, and LA3, regardless of their type, need to be covered at the corresponding viewing angle. If the radii of the emission areas LA1, LA2, and LA3 are different, but the separation distances between the emission areas LA1, LA2, and LA3 and the light blocking patterns BMP1, BMP2, and BMP3 are uniform, one of the emission areas LA1, LA2, and LA3 may be completely covered at a specific viewing angle, while the other emission areas LA1, LA2, and LA3 may not be covered, allowing the light to be visually recognized.

For example, at a specific viewing angle, the second emission area LA2, which has a relatively small radius compared to other emission areas, may be covered to a relatively large extent by the light blocking pattern BMP2. In this case, a relatively little amount of the light emitted from the light emitting layer located on the second emission area LA2 of the second pixel PX2 may be visually recognized at the corresponding viewing angle. When the light emitting layer located on the second emission area LA2 emits green light, a magenta phenomenon with an overall purple color may occur in the display screen at the corresponding viewing angle due to a lack of green light.

In addition, while other emission areas LA1 and LA3 are covered by the light blocking patterns BMP1 and BMP3 at a specific viewing angle, the second emission area LA2 with a relatively small radius may not be covered by the light blocking pattern BMP2. In this case, at the corresponding viewing angle, the light emitted from the light emitting layer located on the second emission area LA2 of the second pixel PX2 may be visually recognized. When the light emitting layer located on the second emission area LA2 emits green light, a greenish phenomenon in which the display screen has an overall green color at the corresponding viewing angle may occur.

In consideration of this, in the display device 10, the differences(for example, separation distances) DF1, DF2, and DF3 between the emission areas and the corresponding the light blocking patterns may be adjusted such that, at a viewing angle where the emission area with a large radius can be covered by the light blocking pattern, the emission area with a small radius can also be covered by the light blocking pattern at a similar proportion. In the display device 10, the differences between the radii PR1, PR2, and PR3 of the emission areas LA1, LA2, and LA3 and the inner radii IR1, IR2, and IR3 of the light blocking patterns BMP1, BMP2, and BMP3, or the separation distances DF1, DF2, and DF3 between the emission areas LA1, LA2, and LA3 and the light blocking patterns BMP1, BMP2, and BMP3 may be different from each other.

Referring to FIG. 17, a difference (a) (e.g., the separation distance DF1, DF2, DF3) between a radius R of the emission area and an inner radius IR of the light blocking pattern may be expressed by the following equation.

$$(a) + 2R \ = Rss + \sum_{k=1}^{n-1} tan\theta_k T_k$$

In the above equation, Rss is a process margin, $\theta_k$ is a final light extraction angle perceived by the user's eyes, and $T_k$ is a total thickness of the layers through which light is transmitted. That is, by calculating a tangent value using the total thickness $T_1+T_2$ and the final light extraction angle $\theta_1+\theta_2$, and then adding the process margin, it is possible to obtain the diameter 2R of an emission area LA and the difference (a) between the radius of the emission area LA and the inner radius IR of a light blocking pattern BMP. In this case, the difference (a) between the radius of the emission area LA and the inner radius IR of the light blocking pattern BMP may be obtained by substituting the radius of the emission area LA. In the present embodiment, the layers through which light is transmitted may be the second passivation layer PSV2 and the second encapsulation layer TFE2 having a large thickness.

In addition, the differential relationship between the widths BW1, BW2, and BW3 of the light blocking patterns BMP1, BMP2, and BMP3 may be opposite to the differential relationship between the radii PR1, PR2, and PR3 of the emission areas LA1, LA2, and LA3. For example, when the widths of the light blocking patterns BMP1, BMP2, and BMP3 are constant, the second emission area LA2 with a small radius may be closer to the outer side surface of the light blocking pattern than the third emission area LA3 with a large radius. In this case, the light emitted from the light emitting layer located on the second emission area LA2 having a small radius may be emitted more easily at a high viewing angle. In consideration of this, the widths BW1, BW2, and BW3 of the light blocking patterns BMP1, BMP2, and BMP3 corresponding to the emission areas LA1, LA2, and LA3 with a small radius may be designed to be larger to prevent light leakage at a high viewing angle.

As shown in FIG. 18, the position where light L emitted at a specific emission angle from one side of the emission areas LA1, LA2, and LA3 reaches the light blocking patterns BMP1, BMP2, and BMP3 may be a position spaced (e.g., spaced apart) from the other side of the emission areas LA1, LA2, and LA3 by a certain distance. Here, the position where the light L emitted at a specific emission angle from the small-diameter emission areas LA1, LA2, and LA3, e.g., the second emission area LA2, reaches the light blocking pattern BMP1, BMP2, BMP3 may be located further away than the position where the light L emitted from the large-diameter emission areas LA1, LA2, and LA3, e.g., the third emission area LA3, reaches the light blocking pattern BMP1, BMP2, BMP3. As described above, the separation distance between the emission areas LA1, LA2, and LA3 and the light blocking patterns BMP1, BMP2, and BMP3 may be smaller for the third light blocking pattern BMP3 as opposed to the size of the emission areas LA1, LA2, and LA3, so that the light L emitted from the second emission area LA2 may be more likely to be emitted beyond the light blocking patterns BMP1, BMP2, and BMP3. In consideration of this, a width BW2 of the second light blocking pattern BMP2 corresponding to the second emission area LA2 having a small radius may be greater than a width BW3 of the third light blocking pattern BMP3. Accordingly, a separation distance DB3 between one side of the third emission area LA3 and the outer side of the third light blocking pattern BMP3 may be smaller than a separation distance DB2 between one side of the second emission area LA2 and the outer side of the second light blocking pattern BMP2. The differential relationship between the widths BW1, BW2, and BW3 of the light blocking patterns BMP1, BMP2, and BMP3 may be opposite to the differential relationship between the radii PR1, PR2, and PR3 of the emission areas LA1, LA2, and LA3.

The display device 10 according to one or more embodiments may include the light blocking area BMA of the color filter layer CFL and the light blocking layer BM to control screen visibility at a specific viewing angle according to the emission mode of the display device 10. In the display device 10, the separation distances and widths of the emission areas LA1, LA2, and LA3, the light blocking area BMA of the color filter layer CFL, and the light blocking layer BM may be designed to ensure that the screen visible to the user does not have a specific color and to prevent a light leakage phenomenon that may occur at a specific viewing angle. The display device 10 may provide a privacy protection mode to the user by blocking visibility at a specific viewing angle.

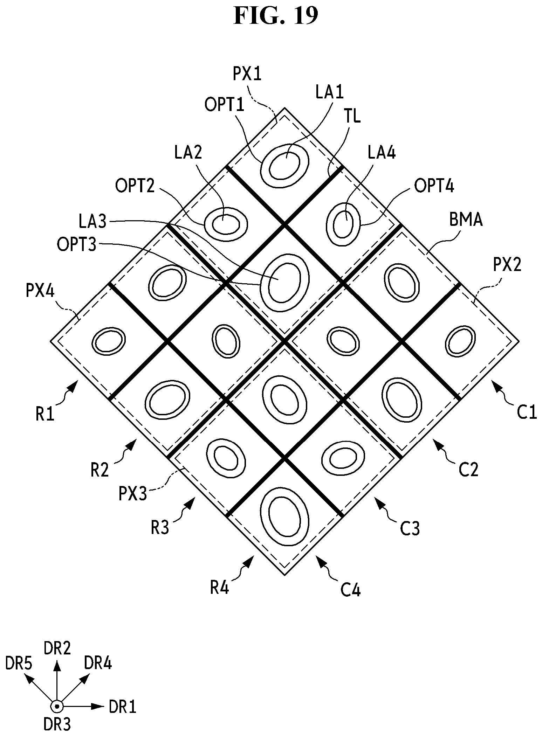

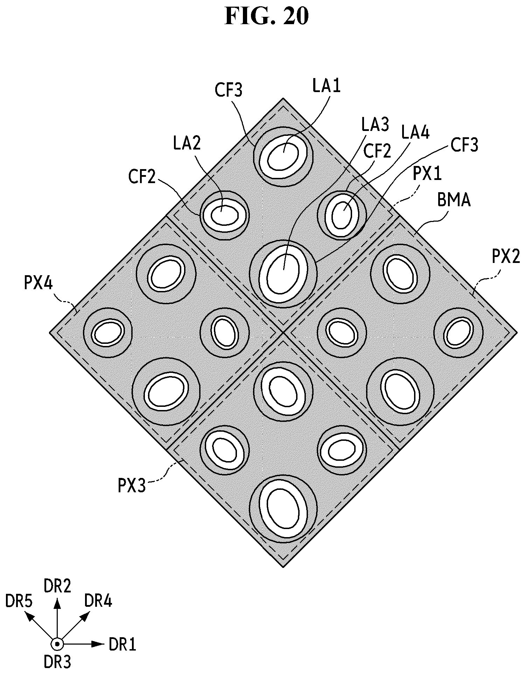

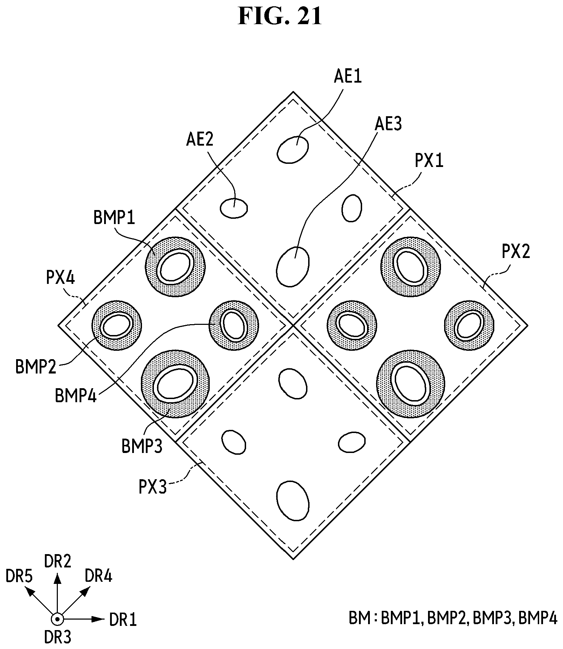

FIG. 19 is a plan view of the arrangement of emission areas in a display area of a display device according to one or more embodiments. FIG. 20 is a plan view showing the arrangement of an emission area and a light blocking area in the display area of the display device of FIG. 19. FIG. 21 is a plan view showing the arrangement of an emission area and a light blocking layer in the display area of the display device of FIG. 19.

Referring to FIGS. 19 - 21, in the display device 10 according to one or more embodiments, the emission areas LA1, LA2, LA3, and LA4 may have an approximately elliptical shape, and accordingly, the light transmitting areas OPT1, OPT2, OPT3, and OPT4 of the color filter layer CFL and the light blocking patterns BMP1, BMP2, BMP3, and BMP4 of the light blocking layer BM may also have an elliptical shape for their inner perimeters but may have a circular shape for their outer perimeters. The display device 10 according to the present embodiment is the same as that in the embodiment of FIGS. 4 - 6, except for the difference in the shapes of the emission areas LA1, LA2, LA3, and LA4, the light transmitting areas OPT1, OPT2, OPT3, and OPT4 of the color filter layer CFL, and the light blocking patterns BMP1, BMP2, BMP3, and BMP4 of the light blocking layer BM.

The length of the emission areas LA1, LA2, LA3, and LA4 measured in one direction may be different from the length measured in another direction. For example, in the first emission area LA1, the length of the major axis passing through the center of the ellipse may be longer than the length of the minor axis. In a single pixel PX1, PX2, PX3, PX4, the emission areas LA1, LA2, LA3, and LA4 may have different lengths for their major axes and minor axes.

In one or more embodiments, the length of the major axis of the first emission area LA1 may be longer than the lengths of the major axes of the second and fourth emission areas LA2 and LA4, but shorter than the length of the major axis of the third emission area LA3. The length of the major axis of the third emission area LA3 may be longer than the length of the major axis of the first emission area LA1 and the lengths of the major axes of the second and fourth emission areas LA2 and LA4. In addition, the length of the minor axis of the first emission area LA1 may be longer than the lengths of the minor axes of the second and fourth emission areas LA2 and LA4, but shorter than the length of the minor axis of the third emission area LA3. The length of the minor axis of the third emission area LA3 may be longer than the length of the minor axis of the first emission area LA1 and the lengths of the minor axes of the second and fourth emission areas LA2 and LA4. The lengths of the major and minor axes of the second and fourth emission areas LA2 and LA4 may be the same.

The major or minor axes of the emission areas LA1, LA2, LA3, and LA4 may extend in different directions. For example, the extension direction of the major axis of the first emission area LA1, the extension direction of the major axis of the second emission area LA2, the extension direction of the major axis of the third emission area LA3, and the extension direction of the major axis of the fourth emission area LA4 may be different from each other. However, the present invention is not limited thereto, and the major or minor axes of the emission areas LA1, LA2, LA3, and LA4 may extend in the same direction.

The light blocking patterns BMP1, BMP2, BMP3, and BMP4 of the light blocking layer BM may be spaced (e.g., spaced apart) from and surround the emission areas LA1, LA2, LA3, and LA4, respectively. As described above, the separation distances between the light blocking patterns BMP1, BMP2, BMP3, and BMP4 and the emission areas LA1, LA2, LA3, and LA4 may vary depending on the sizes of the emission areas LA1, LA2, LA3, and LA4.

In addition, in the display device 10, the widths of the light blocking patterns BMP1, BMP2, BMP3, and BMP4 may also vary depending on the sizes of the emission areas LA1, LA2, LA3, and LA4. According to one or more embodiments, in the display device 10, the second light blocking pattern BMP2, which is located to surround the emission area, e.g., the second emission area LA2, with different lengths measured in different directions, may vary in width depending on its position.

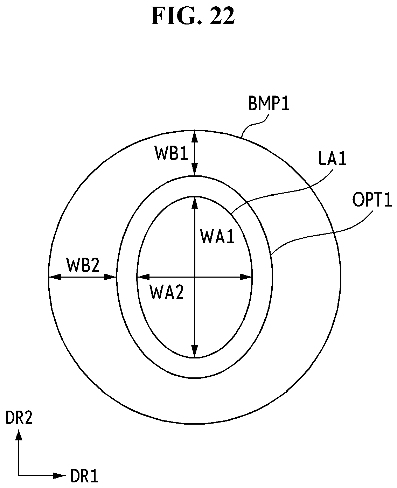

FIG. 22 is a diagram showing the relative arrangement of an emission area and a light blocking layer of the display device of FIG. 21. FIG. 22 schematically illustrates the sizes of the first emission area LA1 and the first light blocking pattern BMP1.

Referring to FIG. 22, in the display device 10, a first length WA1 (e.g., the length of the major axis) of the first emission area LA1 measured in the second direction DR2 may be longer than a second length WA2 (e.g., the length of the minor axis) measured in the first direction DR1. The first light blocking pattern BMP1 may surround the first emission area LA1 and may be spaced (e.g., spaced apart) therefrom by a certain distance, and the region surrounded by the first light blocking pattern BMP1 may form the first light output portion OPB1. As described above, in order to prevent a light leakage phenomenon at a high viewing angle, as the diameter of the emission area decreases, the width of the light blocking pattern surrounding the pixel electrode AE may increase.

The first light blocking pattern BMP1 may have an elliptical inner perimeter similar to the first emission area LA1, but a circular outer perimeter. Accordingly, a first width WB1 of the first light blocking pattern BMP1, measured along the extension line of the first length WA1 of the first emission area LA1, may be smaller than a second width WB2, measured along the extension line of the second length WA2 of the first emission area LA1. The first length WA1 of the first emission area LA1 may be longer than the second length WA2, and the first width WB1 of the first light blocking pattern BMP1 located along the extended major axis of the first emission area LA1 may be smaller than the second width WB2 located along the extended minor axis of the first emission area LA1.

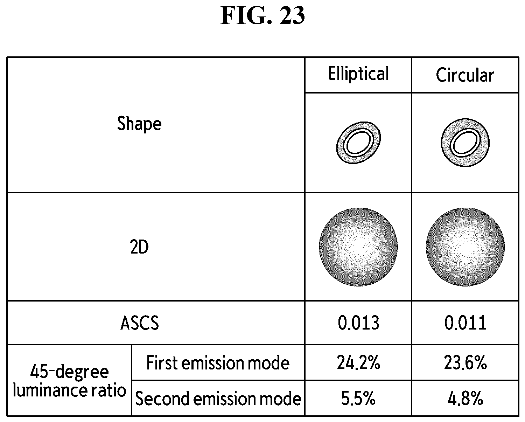

FIG. 23 is a table illustrating a 45-degree luminance ratio and a color variation according to an azimuth angle based on the shape of the outer perimeter of a light blocking pattern.

Referring to FIG. 23, compared to the light blocking pattern with an elliptical outer perimeter, the light blocking pattern with a circular outer perimeter showed a reduction in a color variation value ASCS according to the azimuth angle by approximately 0.002. In addition, in the second emission mode (e.g., the privacy protection mode), the luminance ratio at a 45-degree viewing angle decreased by approximately 0.7%.

From this result, it may be confirmed that the light blocking pattern with a circular outer perimeter exhibits less color variation according to the viewing angle and blocks more light at a side viewing angle, thereby implementing an improved privacy protection mode.

The display device 10 according to one or more embodiments may provide a privacy protection mode to the user by designing the shape and width of the light blocking pattern in various ways to correspond to the shape and size of the emission area.

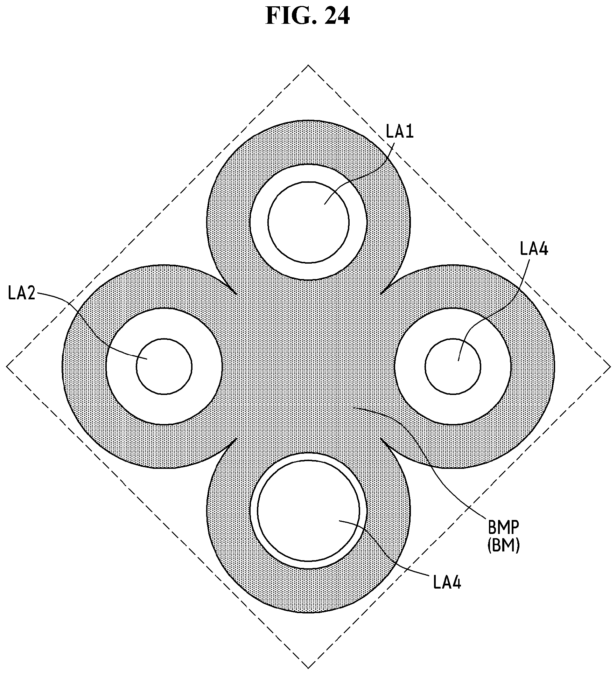

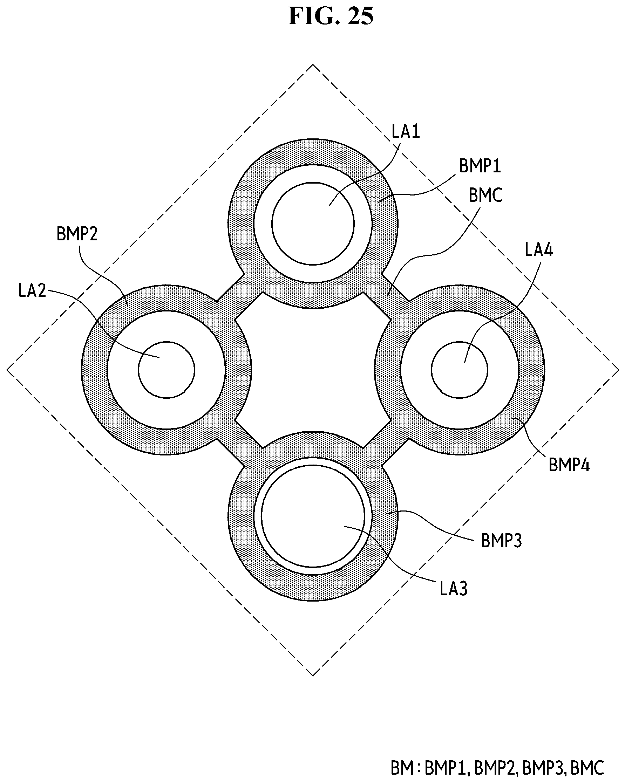

FIGS. 24 and 25 are views showing a light blocking pattern of a display device according to one or more embodiments.

Referring to FIG. 24, in the light blocking layer BM according to one or more embodiments, the light blocking patterns BMP1, BMP2, BMP3, and BMP4 (see FIG. 10) located to correspond to and surround the respective emission areas LA1, LA2, LA3, and LA4 may be integrated. The present embodiment differs from the embodiment of FIG. 16 in that the light blocking patterns BMP1, BMP2, BMP3, and BMP4 are integrated. In the following description, redundant description of the above-described embodiments will be omitted while focusing on differences.

The light blocking layer BM may be formed through a patterning process using a mask. According to one or more embodiments, a large pattern integrated with each other rather than to form a plurality of patterns that are spaced (e.g., spaced apart) from each other. Accordingly, the display device 10 may include a single light blocking pattern BMP located to correspond to each of the second type pixels (or the second pixel PX2 and the fourth pixel PX4), but the light blocking pattern BMP may have a shape that surrounds each of the emission areas LA1, LA2, LA3, and LA4 without covering them.

Referring to FIG. 25, in the light blocking layer BM according to one or more embodiments, the light blocking patterns BMP1, BMP2, BMP3, and BMP4 located to correspond to and surround the respective emission areas LA1, LA2, LA3, and LA4 may be connected to each other. The present embodiment differs from the embodiment of FIG. 16 in that the light blocking patterns BMP1, BMP2, BMP3, and BMP4 are connected through a connection portion BMC. Alternatively, the present embodiment differs from the embodiment of FIG. 24 in that the center of the light blocking pattern BMP is removed.

As described above, in the mask process for forming the light blocking layer BM, according to one or more embodiments, one large pattern may be formed rather than to form a plurality of patterns that are spaced (e.g., spaced apart) from each other. In addition, when the area in which the light blocking layer BM is located may be reduced or minimized, it may be more suitable in terms of color adjustment. In the display device 10, the plurality of light blocking patterns BMP1, BMP2, BMP3, and BMP4 located to correspond to the respective emission areas LA1, LA2, LA3, and LA4 of each of the second type pixels (or the second pixel PX2 and the fourth pixel PX4) may have a shape in which they are connected to another adjacent pattern through the connection portion BMC.

In concluding the detailed description, those skilled in the art will appreciate that many variations and modifications can be made to the embodiments without substantially departing from the principles and scope of the present invention. Therefore, the embodiments of the present invention are used in a generic and descriptive sense only and not for purposes of limitation.

**Claims**

1. A display device (10) comprising:

   a display area (DA) in which a plurality of pixels (PX1-PX4) comprising a plurality of emission areas (LA1-LA4) spaced from each other is located;
   a color filter layer (CFL) located in the display area (DA) and comprising a plurality of color filters (CF1-CF3) overlapping the plurality of emission areas (LA1-LA4); and
   a light blocking layer (BM) located on the color filter layer (CFL) and corresponding to the plurality of emission areas (LA1-LA4) of some of the plurality of pixels (PX1-PX4),
   wherein the color filter layer (CFL) comprises a light blocking area (BMA) in which at least two of the plurality of color filters (CF1-CF3) overlap, and a plurality of light transmitting areas (OPT1-OPT4), which are areas other than the light blocking area (BMA), and
   wherein the light blocking area (BMA) overlaps the light blocking layer (BM), and the plurality of light transmitting areas (OPT1-OPT4) do not overlap the light blocking layer (BM).

2. The display device (10) of claim 1, wherein the plurality of color filters (CF1-CF3) comprises a first color filter (CF1), a second color filter (CF2), and a third color filter (CF3) that transmit light of different colors, and
   wherein the light blocking area (BMA) comprises a region where at least the first color filter (CF1) and the second color filter (CF2) overlap in a thickness direction of the display device (10) and a region where at least the first color filter (CF1) and the third color filter (CF3) overlap in the thickness direction.

3. The display device (10) of claim 1 or 2, wherein the plurality of color filters (CF1-CF3) comprises a first color filter (CF1), a second color filter (CF2), and a third color filter (CF3), and

wherein the plurality of light transmitting areas (OPT1-OPT4) comprises a region where only one color filter (CF1-CF3) from among the first color filter (CF1), the second color filter (CF2), and the third color filter (CF3) is located.

4. A display device (10) comprising:

a substrate (SUB);
a light emitting element layer (EML) located on the substrate (SUB) and comprising a plurality of emission areas (LA1-LA4);
an encapsulation layer (TFEL) located on the light emitting element layer (EML);
a color filter layer (CFL) located on the encapsulation layer (TFEL) and comprising a plurality of light transmitting areas (OPT1-OPT4) respectively overlapping the plurality of emission areas (LA1-LA4), and a light blocking area (BMA) not overlapping the plurality of emission areas (LA1-LA4); and
a light blocking member layer (PML) located on the color filter layer (CFL) and comprising a light blocking layer (BM) located to respectively correspond to the plurality of emission areas (LA1-LA4),
wherein the color filter layer (CFL) comprises a first color filter (CF1-CF3), a second color filter (CF2), and a third color filter (CF3), and
wherein the light blocking area (BMA) comprises a region where at least the first color filter (CF1) and the second color filter (CF2) overlap in a thickness direction of the display device (10) and a region where at least the first color filter (CF1) and the third color filter (CF3) overlap in the thickness direction.

5. The display device (10) of claim 4, wherein the plurality of light transmitting areas (OPT1-OPT4) comprises a region where only one color filter (CF1-CF3) from among the first color filter (CF1), the second color filter (CF2), and the third color filter (CF3) is located.

6. The display device (10) of at least one of claims 1 to 5, wherein the plurality of emission areas (LA1-LA4) comprises a first emission area (LA1), a second emission area (LA2), and a third emission area (LA3) spaced from each other, and
wherein the plurality of light transmitting areas (OPT1-OPT4) comprises a first light transmitting area (OPT1) overlapping the first emission area (LA1), a second light transmitting area (OPT2) overlapping the second emission area (LA2), and a third light transmitting area (OPT3) overlapping the third emission area (LA3).

7. The display device (10) of at least one of claims 2 to 5 and of claim 6, wherein the first color filter (CF1) is around the first emission area (LA1) and the second emission area (LA2) in a plan view and overlaps the second color filter (CF2) or the third color filter (CF3) in the light blocking area (BMA),

wherein the second color filter (CF2) is around the second emission area (LA2) and the third emission area (LA3) in a plan view and overlaps the first color filter (CF1) in the light blocking area (BMA), and
wherein the third color filter (CF3) is around the first emission area (LA1) and the third emission area (LA3) in a plan view and overlaps the first color filter (CF1) to form the light blocking area (BMA).

8. The display device (10) of claim 6 or 7, wherein the light blocking layer (BM) comprises a first light output portion (OPB1) overlapping the first emission area (LA1), a second light output portion (OPB2) overlapping the second emission area (LA2), and a third light output portion (OPB3) overlapping the third emission area (LA3),

wherein an inner side surface of the first light transmitting area (OPT1) is aligned with an inner side surface of the first light output portion (OPB1),
wherein an inner side surface of the second light transmitting area (OPT2) is aligned with an inner side surface of the second light output portion (OPB2), and
wherein an inner side surface of the third light transmitting area (OPT3) is aligned with an inner side surface of the third light output portion (OPB3).

9. The display device (10) of at least one of claims 1 to 8, wherein the plurality of emission areas (LA1-LA4) comprises a first emission area (LA1), a second emission area (LA2), and a third emission area (LA3) spaced from each other, and
wherein the first emission area (LA1), the second emission area (LA2), and the third emission area (LA3) are located at different distances (W1, W2, W3) from the light blocking area (BMA).

10. The display device (10) of claim 9, wherein a distance (W1) between the first emission area (LA1) and the light blocking area (BMA) is smaller than a distance (W2) between the second emission area (LA2) and the light blocking area (BMA), and is smaller than a distance (W3) between the third emission area (LA3) and the light blocking area (BMA), and
wherein the distance (W2) between the second emission area (LA2) and the light blocking area (BMA) is larger than the distance (W3) between the third emission area (LA3) and the light blocking area (BMA).

11. The display device (10) of at least one of claims 1 to 10, wherein the light blocking layer (BM) surrounds the plurality of emission areas (LA1-LA4) in a plan view and comprises a plurality of light blocking patterns (BMP1-BMP4) spaced from each other.

12. The display device (10) of claim 11, wherein the plurality of pixels (PX1-PX4) comprises a first emission area (LA1), and a second emission area (LA2) having a smaller radius (PR2) than the first emission area (LA1),

  wherein the light blocking layer (BM) comprises a first light blocking pattern (BMP1) corresponding to the first emission area (LA1), and a second light blocking pattern (BMP2) corresponding to the second emission area (LA2), and
  wherein a difference (DF1) between a radius (PR1) of the first emission area (LA1) and an inner radius (IR1) of the first light blocking pattern (BMP1) is different from a difference (DF2) between a radius (PR2) of the second emission area (LA2) and an inner radius (IR2) of the second light blocking pattern (BMP2).

13. The display device (10) of claim 12, wherein a width (BW1) of the first light blocking pattern (BMP1) is smaller than a width (BW2) of the second light blocking pattern (BMP2).

14. The display device (10) of at least one of claims 11 to 13, wherein the plurality of pixels (PX1-PX4) comprises a first pixel (PX1) in which the light blocking layer (BM) is not located, and a second pixel (PX2) in which the light blocking patterns (BMP1-BMP4) are located to respectively correspond to the plurality of emission areas (LA1-LA4), and
wherein a diameter of the plurality of light transmitting areas (OPT1-OPT4) in the first pixel (PX1) is larger than a diameter of the plurality of light transmitting areas (OPT1-OPT4) in the second pixel (PX1).

15. The electronic device of at least one of claims 1 to 14, wherein the light blocking layer (BM) is around the plurality of emission areas (LA1-LA4) in a plan view and comprises a plurality of light blocking patterns (BMP1-BMP4) spaced from each other;

  wherein the plurality of emission areas (LA1-LA4) has a planar shape corresponding to a shape of inner perimeters of the plurality of light blocking patterns (BMP1-BMP4), and

wherein a shape of outer perimeters of the plurality of light blocking patterns (BMP1-BMP4) is different from the shape of the inner perimeters.

16. The electronic device of claim 15, wherein the planar shape of the plurality of emission areas (LA1-LA4) and the shape of the inner perimeters of the plurality of light blocking patterns (BMP1-BMP4) are elliptical, and
wherein the shape of the outer perimeters of the plurality of light blocking patterns (BMP1-BMP4) is circular.

17. An electronic device (1) comprising a display device according to at least one of claims 1 to 16.

# FIG. 1

# FIG. 2

# FIG. 3

# FIG. 4

# FIG. 5

## FIG. 6

FIG. 7

**FIG. 8**

# FIG. 9

BM : BMP1, BMP2, BMP3, BMP4

**FIG. 10**

PX1

BMP1

PX4

PX2

BMP2

BMP4

BMP3

PX3

DR2
DR5    DR4

DR1

DR3

BM : BMP1, BMP2, BMP3, BMP4

# FIG. 11

# FIG. 12

CFL : CF1, CF2, CF3

# FIG. 13

# FIG. 14

# FIG. 15

# FIG. 16

BM : BMP1, BMP2, BMP3, BMP4

## FIG. 17

# FIG. 18

# FIG. 19

# FIG. 20

# FIG. 21

BM : BMP1, BMP2, BMP3, BMP4

**FIG. 22**

# FIG. 23

| | | Elliptical | Circular |
|---|---|---|---|
| Shape | | | |
| 2D | | | |
| ASCS | | 0.013 | 0.011 |
| 45-degree luminance ratio | First emission mode | 24.2% | 23.6% |
| | Second emission mode | 5.5% | 4.8% |

# FIG. 24

# FIG. 25

BM : BMP1, BMP2, BMP3, BMC

## EUROPEAN SEARCH REPORT

Europäisches
Patentamt
European
Patent Office
Office européen
des brevets

**Application Number**

EP 25 18 2603

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 923 343 A1 (SAMSUNG DISPLAY CO LTD [KR]) 15 December 2021 (2021-12-15) | 1-7, 9-11,15, 17 | INV. H10K59/35 H10K59/38 |
| A | * figures 1A,5,7,8,9,13 * <br> * paragraph [0003] * <br> * paragraph [0038] * <br> * paragraph [0043] * <br> * paragraph [0051] - paragraph [0053] * <br> * paragraph [0055] - paragraph [0056] * <br> * paragraph [0060] * <br> * paragraph [0091] * <br> * paragraph [0102] - paragraph [0103] * <br> * paragraph [0107] * <br> * paragraph [0146] * <br> * paragraph [0149] * <br> * paragraph [0156] * <br> ----- | 12-14,16 | H10K59/80 |
| X | CN 221 081 904 U (SAMSUNG DISPLAY CO LTD) 4 June 2024 (2024-06-04) <br> * figures 1,4,5A,5B * <br> * paragraph [0042] * <br> * paragraph [0044] * <br> * paragraph [0059] * <br> * paragraph [0075] * <br> * paragraph [0116] * <br> * paragraph [0118] * <br> ----- | 1,6,8 | |
| X | US 2022/140041 A1 (LEE HYEONBUM [KR] ET AL) 5 May 2022 (2022-05-05) <br> * paragraph [0002]; figures 1,11,12A * <br> * paragraph [0056] * <br> * paragraph [0092] - paragraph [0093] * <br> * paragraph [0130] * <br> * paragraph [0245] * <br> * paragraph [0248] * <br> * paragraph [0257] * <br> ----- | 1 | |

**TECHNICAL FIELDS SEARCHED (IPC)**

H10K

The present search report has been drawn up for all claims

| Place of search | Date of completion of the search | Examiner |
|---|---|---|
| The Hague | 6 November 2025 | Baum, Thomas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 2603

This annex lists the patent family members relating to the patent documents cited in the above-mentioned European search report.
The members are as contained in the European Patent Office EDP file on
The European Patent Office is in no way liable for these particulars which are merely given for the purpose of information.

06-11-2025

| Patent document cited in search report | | Publication date | Patent family member(s) | | Publication date |
|---|---|---|---|---|---|
| EP 3923343 | A1 | 15-12-2021 | CN | 113809128 A | 17-12-2021 |
| | | | EP | 3923343 A1 | 15-12-2021 |
| | | | EP | 4398697 A2 | 10-07-2024 |
| | | | KR | 20210154315 A | 21-12-2021 |
| | | | US | 2021391389 A1 | 16-12-2021 |
| CN 221081904 | U | 04-06-2024 | CN | 221081904 U | 04-06-2024 |
| | | | KR | 20240043845 A | 04-04-2024 |
| | | | US | 2024107847 A1 | 28-03-2024 |
| US 2022140041 | A1 | 05-05-2022 | CN | 114447040 A | 06-05-2022 |
| | | | KR | 20220060626 A | 12-05-2022 |
| | | | US | 2022140041 A1 | 05-05-2022 |
| | | | US | 2024284725 A1 | 22-08-2024 |

EPO FORM P0459

For more details about this annex : see Official Journal of the European Patent Office, No. 12/82